# EUROPEAN PATENT APPLICATION

(11) **EP 2 407 494 A1**
(43) Date of publication of application: **18.01.2012**
(21) Application number: 10750790.7
(22) Date of filing: 08.03.2010
(51) Int. Cl.: C08F 36/20, H01L 29/786, H01L 51/05, H01L 51/30, H01L 51/42

(54) **POLYMER, ORGANIC THIN FILM COMPRISING THE POLYMER, AND ORGANIC THIN-FILM ELEMENT INCLUDING SAME**

(30) Priority: 11.03.2009 JP 2009058656
(71) Applicant: Sumitomo Chemical Company, Limited, Tokyo 104-8260 (JP); Osaka University, Suita-shi Osaka 565-0871 (JP)
(72) Inventor: IE Yutaka, Suita-shi Osaka 565-0871 (JP); YOSHIMURA Atsuki, Suita-shi Osaka 565-0871 (JP); ASO Yoshio, Suita-shi Osaka 565-0871 (JP); UEDA Masato, Tsukuba-shi Ibaraki 305-0046 (JP)
(74) Representative: Duckworth, Timothy John
(86) International application number: PCT/JP2010/053797
(87) International publication number: WO 2010/104037

(57) **Abstract**

An object of the present invention is to provide a polymer having a low LUMO, a high charge transport property, and further high solubility in a solvent. The present invention provides a polymer having a repeating unit represented by the formula (I): 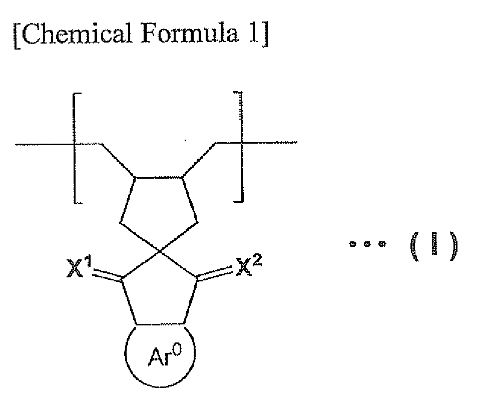 wherein Ar⁰ means an aromatic ring that may have a substituent or substituents, or a heterocycle that may have a substituent or substituents, and X¹ and X² are the same or different and each mean an oxygen atom or a sulfur atom.

## Description

### Technical Field

The present invention relates to a polymer and a monomer, as well as an organic thin film using the polymer, an organic thin-film element, an organic thin film transistor, an organic solar cell and a photosensor that comprise the organic thin film.

### Background Art

As a material for an organic thin-film element, such as an organic transistor, an organic solar cell, and a photosensor, various conjugated compounds, which are organic n-type semiconductor materials, have been developed. As a specific example of such conjugated compounds, a compound of oligothiophene having a thiophene ring in the main chain, the end of the oligothiophene being introduced with a fluoroalkyl group, has been proposed (Patent Literature 1).

### Citation List

### Patent Literature

Patent Literature 1: International Publication WO 2003/010778

### Summary of Invention

### Technical Problem

It is preferable for an organic thin-film element using an organic semiconductor material to have a high charge transport property, and in order to obtain the charge transport property it is desirable to have high conjugation and a low LUMO. Meanwhile, from the viewpoint of commercializing an organic thin-film element, an organic semiconductor material is required, in addition to having a high charge transport property, to be able to form a good organic thin film at a low cost. If an organic semiconductor material has high solubility in a solvent, a large area homogenous film can be formed easily by coating. A conventional conjugated compound has had, however, a tendency to lose solubility in a solvent down to a very low level, especially if an attempt is made to attain a low LUMO.

Under such circumstances the present invention was made with an object to provide a polymer having a low LUMO, a high charge transport property, and further high solubility in a solvent. Other objects of the present invention are to provide a monomer for obtaining the polymer, an organic thin film using the polymer, and an organic thin-film element comprising the organic thin film, such as an organic thin film transistor, an organic solar cell, and a photosensor.

### Solution to Problem

To attain the objects, a polymer according to the present invention is characterized by having a repeating unit represented by formula (1), 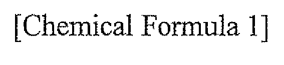 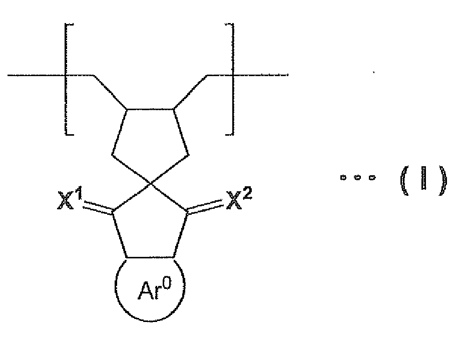 wherein Ar⁰ means an aromatic ring which may have a substituent or substituents, or a heterocycle which may have a substituent or substituents, and X¹ and X² are the same or different and each mean an oxygen atom or a sulfur atom.

The polymer according to the present invention has a low LUMO, because a side chain moiety contained in the repeating unit represented by the formula (1) has X¹ and X², and the side chain moiety as a whole has high conjugation, because the side chain moiety has a conjugate structure derived from double bonds binding X¹ and X² and a structure represented by Ar⁰. Consequently, the polymer according to the present invention can exhibit an excellent charge transport property. Further it has high solubility in a solvent, because a part connecting with the main chain constitutes a flexible structure.

In the polymer according to the present invention, the repeating unit represented by the formula (I) is preferably a repeating unit represented by formula (I-a). By having such a repeating unit, the polymer can have a side chain with a lower LUMO and higher conjugation, and the solubility tends to be increased further. 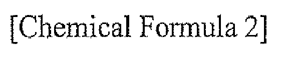 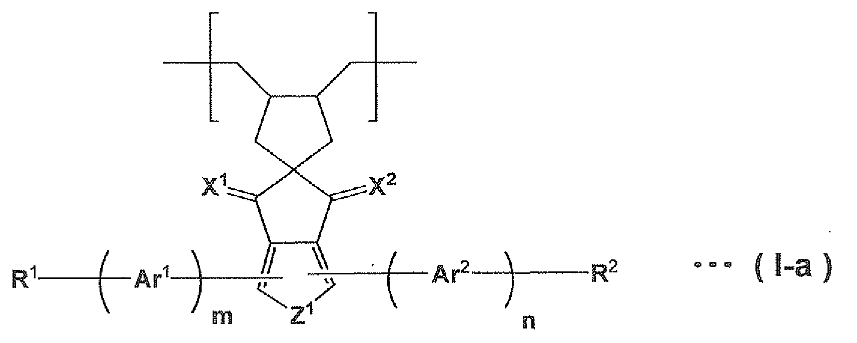 wherein X¹ and X² have the same meanings as defined hereinabove 1, Ar¹ and Ar² are the same or different and each mean a C6 or higher divalent aromatic hydrocarbon group which may have a substituent or substituents, or a C4 or higher divalent heterocyclic group which may have a substituent or substituents, and R¹ and R² are the same or different and each mean a hydrogen atom, a halogen atom, or a monovalent group; m and n are the same or different and are each an integer of 0 to 6; and Z¹ means any of groups represented by formulas (i), (ii), (iii), (iv), (v), (vi), (vii), (viii) and (ix), (hereinafter occasionally written as "(i) to (ix)"), wherein R³, R⁴, R⁵ and R⁶ are the same or different and each mean a hydrogen atom or a monovalent group, R³ and R⁴ may be bonded together to form a ring, and a group represented by the formula (iv) may be reversed from left to right; if a plurality of Ar¹ or Ar² is present, the plurality of Ar¹ or Ar² may be the same or different.

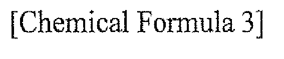

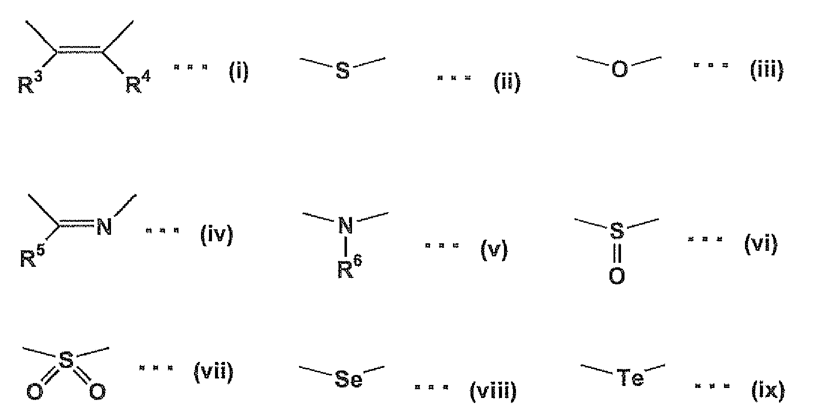

From the viewpoint of enhancing further the conjugation so as to improve the charge transport property, Ar¹ and Ar² in the formula (I-a) are the same or different and are each preferably a group represented by formula (II); 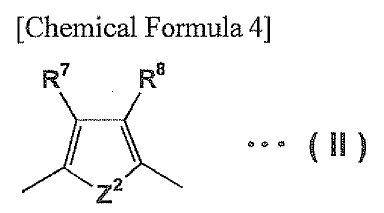 wherein R⁷ and R⁸ are the same or different and each mean a hydrogen atom or a monovalent group, Z² means any of groups represented by formulas (xi), (xii), (xiii), (xiv), (xv), (xvi), (xvii), (xviii) and (xix), wherein R⁹, R¹⁰, R¹¹ and R¹² are the same or different and each mean a hydrogen atom or a monovalent group, R⁹ and R¹⁰ may be bonded together to form a ring, and a group represented by the formula (xiv) may be reversed from left to right.

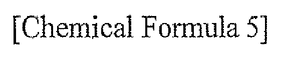

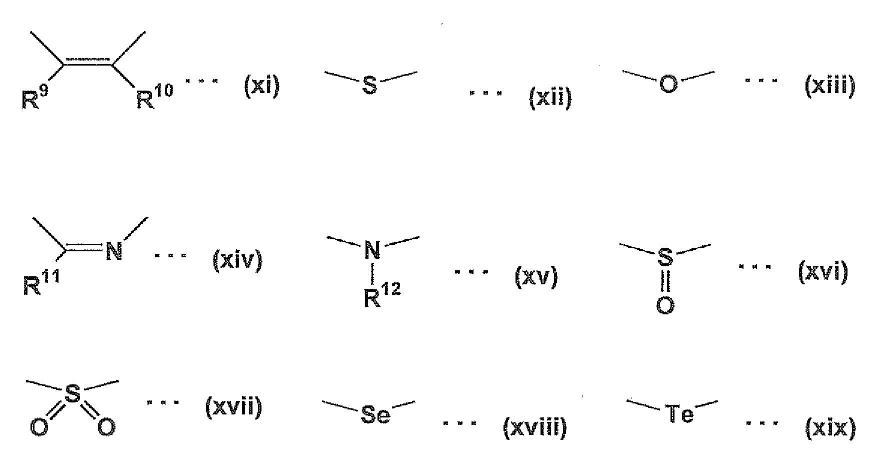

Further, in the formula (I-a) Z¹ is preferably a group represented by the formula (ii), and in the formula (II) Z² is preferably a group represented by the formula (xii). A polymer having such a structure can exhibit a still better charge transport property.

In the formula (I-a), at least one of R¹ and R² is preferably a group represented by formula (III). By having the groups at the end of the side chain, the LUMO can be further lowered and a better charge transport property can be obtained. 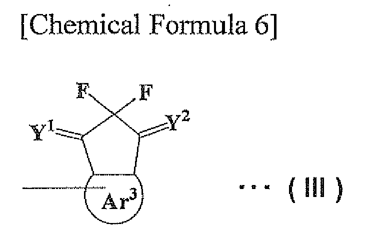 wherein Ar³ means a trivalent aromatic hydrocarbon group which may have a substituent or substituents, or a trivalent heterocyclic group which may have a substituent or substituents, and Y¹ and Y² are the same or different and each mean an oxygen atom, a sulfur atom, or a group represented by formula (a); 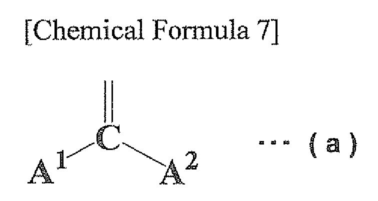 wherein A¹ and A² are the same or different and each mean a hydrogen atom, a halogen atom, or a monovalent group, and at least one af A¹ and A² is an electron-withdrawing group.

Especially for a group represented by the formula (III) is suitably a group represented by formula (IV): 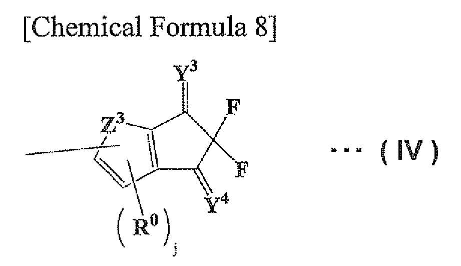 wherein Y³ and Y⁴ are the same or different and each mean an oxygen atom, a sulfur atom, or a group represented by the formula (a), R⁰ means a hydrogen atom or a monovalent group, and j is an integer from 1 to the number of sites that can be substituted in a ring that R⁰ is bonded to; if a plurality of R⁰ is present, R⁰ may be the same or different; and Z³ means any of groups represented by formulas (xxi), (xxii), (xxiii), (xxiv), (xxv), (xxvi), (xxvii), (xxviii) and (xxix), wherein R¹³, R¹⁴, R¹⁵ and R¹⁶ are the same or different and each mean an hydrogen atom or a monovalent group, R¹³ and R¹⁴ may be bonded together to form a ring, and a group represented by the formula (xxiv) may be reversed from left to right.

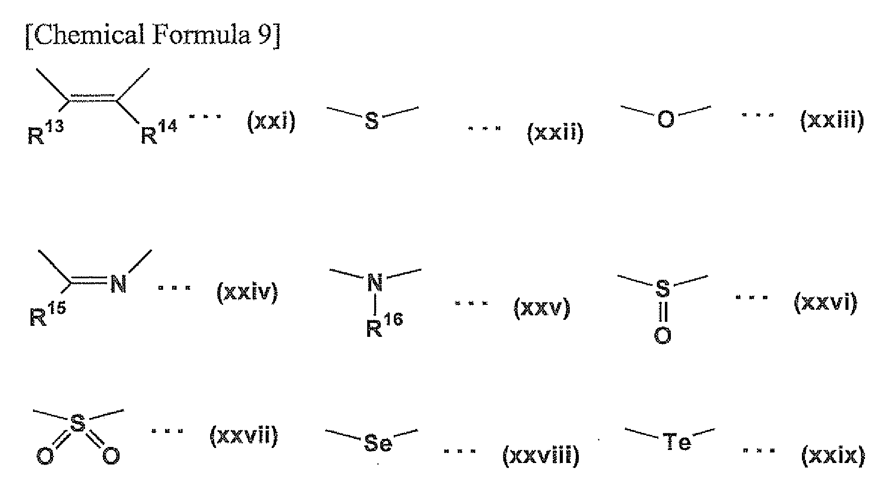

Further, the present invention provides a monomer represented by formula (XI). The monomer according to the present invention can easily produce by polymerization an afore-described polymer according to the present invention and is very useful for producing a polymer having a low LUMO and a superior charge transport property, as well as high solubility in a solvent. 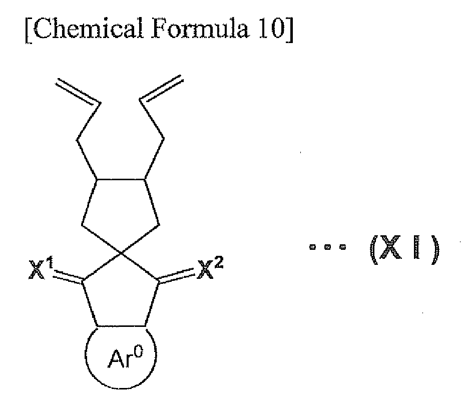 wherein Ar⁰ means an aromatic ring which may have a substituent or substituents, or a heterocycle which may have a substituent or substituents, and X¹ and X² are the same or different and each mean an oxygen atom or a sulfur atom.

A monomer represented by formula (XI-a) is more preferable as a monomer according to the present invention. With such a monomer a polymer better than those described above becomes available easily. 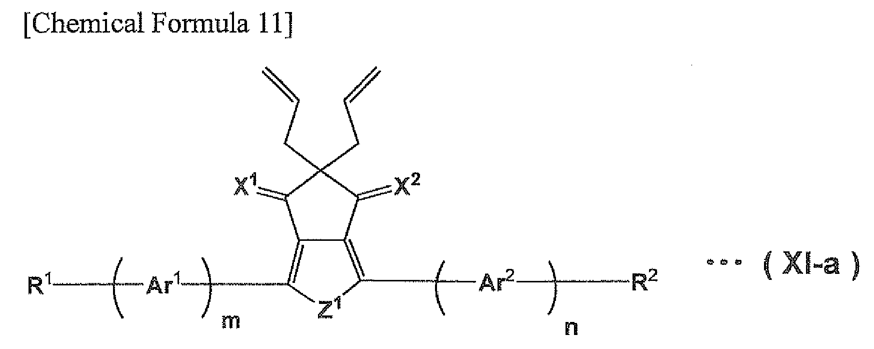 wherein Ar¹ and Ar² are the same or different and each mean a C6 or higher divalent aromatic hydrocarbon group or a C4 or higher divalent heterocyclic group, R¹ and R² are the same or different and each mean a hydrogen atom, a halogen atom, or a monovalent group, and X¹ and X² are the same or different and each mean an oxygen atom or a sulfur atom; m and n are the same or different and are each an integer of 0 to 6; Z¹ means any of groups represented by formulas (i), (ii), (iii), (iv), (v), (vi), (vii), (viii) and (ix), wherein R³, R⁴, R⁵ and R⁶ are the same or different and each mean a hydrogen atom or a monovalent group, R³ and R⁴ may be bonded together to form a ring, and a group represented by the formula (iv) may be reversed from left to right; and it should be noted that if a plurality of Ar¹ or Ar² is present, the plurality of Ar¹ or Ar² may be the same or different.

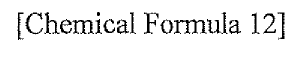

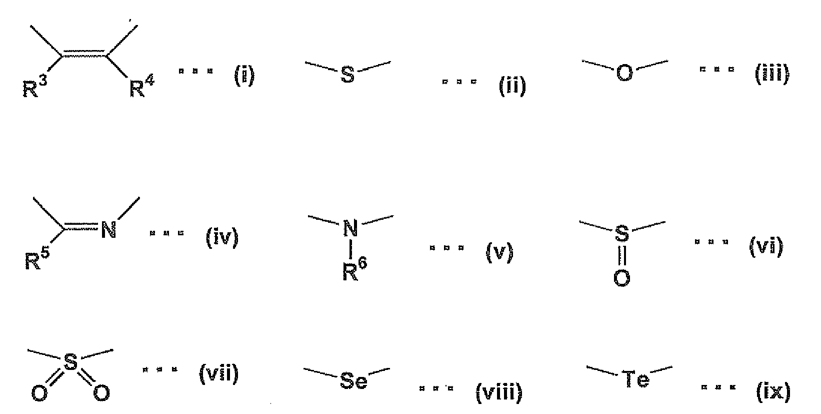

The present invention provides also an organic thin film containing the polymer according to the present invention. Since an organic thin film according to the present invention contains the polymer according to the present invention, it has a high charge transport property and can be formed to a film by coating, and consequently can have a homogenous property even if its area is large, and can provide various organic thin films containing such organic thin film.

More specifically, the present invention provides an organic thin film transistor comprising a source electrode, a drain electrode, an organic semiconductor layer which forms a current pathway between the electrodes, and a gate electrode to control the amount of current through the current pathway, wherein the organic semiconductor layer comprises an organic thin film according to the present invention. Since the organic semiconductor layer comprises an organic thin film according to the present invention, the organic thin film transistor can exhibit a high charge transport property and therefore can have high performance as a transistor.

The present invention provides further an organic solar cell and a photosensor containing the organic thin film according to the present invention. By containing the organic thin film according to the present invention, the organic thin-film elements can acquire adequately the charge transport property required for functioning of the respective elements and can give excellent characteristics.

### Advantageous Effects of Invention

According to the present invention, it is possible to provide a polymer having a low LUMO, a high charge transport property, and further high solubility in a solvent. Further, a monomer for obtaining the polymer, an organic thin film using the polymer, and an organic thin-film element comprising the organic thin film, such as an organic thin film transistor, an organic solar cell, and a photosensor, can be made available.

### Brief Description of Drawings

[Figure 1] Figure 1 is a schematic sectional view of an organic thin film transistor according to the first embodiment.
[Figure 2] Figure 2 is a schematic sectional view of an organic thin film transistor according to the second embodiment.
[Figure 3] Figure 3 is a schematic sectional view of an organic thin film transistor according to the third embodiment.
[Figure 4] Figure 4 is a schematic sectional view of an organic thin film transistor according to the fourth embodiment.
[Figure 5] Figure 5 is a schematic sectional view of an organic thin film transistor according to the fifth embodiment.
[Figure 6] Figure 6 is a schematic sectional view of an organic thin film transistor according to the sixth embodiment.
[Figure 7] Figure 7 is a schematic sectional view of an organic thin film transistor according to the seventh embodiment.
[Figure 8] Figure 8 is a schematic sectional view of a solar cell according to an embodiment.
[Figure 9] Figure 9 is a schematic sectional view of a photosensor according to the first embodiment.
[Figure 10] Figure 10 is a schematic sectional view of a photosensor according to the second embodiment.
[Figure 11] Figure 11 is a schematic sectional view of a photosensor according to the third embodiment.

### Description of Embodiments

Appropriate embodiments with respect to the present invention will be described below in detail occasionally referring to the drawings. In describing the drawings, the same reference sign will be assigned to the same element, and a duplicated description will be omitted. An expression about a positional relationship, such as top, bottom, left and right, will be based on the positional relationship in a drawing. Further, a dimensional ratio with respect to a drawing is not limited to the depicted ratio.

### [Polymer]

A polymer according to the present embodiment has a repeating unit represented by formula (I). Since such polymer has a side chain moiety with high conjugation (π conjugated system), it can be used as an organic n-type semiconductor. Further, since it has a flexible structure at a connecting part with the main chain, its solubility in a solvent is superior, and a substantially homogenous organic thin film can be formed using a solution. Consequently, by using such polymer, an organic thin-film element with high performance can be produced.

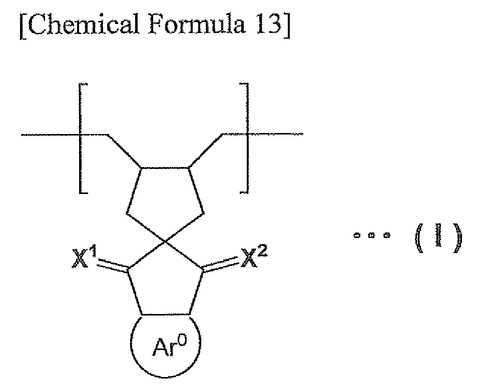

In the formula (I) Ar⁰ means an aromatic ring which may have a substituent or substituents, or a heterocycle which may have a substituent or substituents. X¹ and X² are the same or different and each mean an oxygen atom or a sulfur atom; and an oxygen atom is preferable.

Examples of the aromatic ring for Ar⁰ include a benzene ring and a condensed ring, and those with C6 to C60 are preferable, and those with C6 to C20 are more preferable. Examples of the condensed ring include a naphthalene ring, an anthracene ring, a tetracene ring, a pentacene ring, a pyrene ring, a perylene ring, and a fluorene ring. Examples of the substituent which the aromatic ring may possess include a halogen atom, a saturated or unsaturated hydrocarbon group, an aryl group, an alkoxy group, an aryloxy group, a monovalent heterocyclic group, an amino group, a nitro group, and a cyano group.

As a heterocycle, a C4 to C60 heterocycle is preferable, and a C4 to C20 heterocycle is more preferable. Examples of such heterocycle include thiophene, thienothiophene, dithienothiophene, thiazole, pyrrole, pyridine, and pyrimidine. Examples of the substituent which the heterocycle may possess include similar substituents, which an aromatic ring may possess, as described above.

A repeating unit represented by formula (I-a) is appropriate as a repeating unit represented by the formula (I).

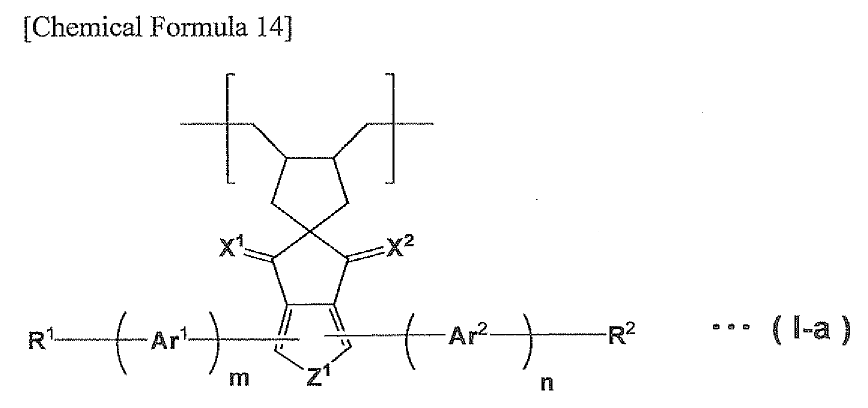

In the formula (I-a), X¹ and X² have the same meanings as defined hereinabove. Ar¹ and Ar² are the same or different and each mean a C6 or higher divalent aromatic hydrocarbon group which may have a substituent or substituents, or a C4 or higher divalent heterocyclic group which may have a substituent or substituents, R¹ and R² are the same or different and each mean a hydrogen atom, a halogen atom, or a monovalent group. m and n are the same or different and each mean an integer of 0 to 6, and an integer of 0 to 3 is preferable, and an integer of 0 to 1 is more preferable. From the viewpoint of ease of production of a polymer, m = n is especially preferable. If a plurality of Ar¹ or Ar² is present, the plurality of Ar¹ or Ar² may be the same or different.

In the formula (I-a), Z¹ means any of groups represented by formulas (i), (ii), (iii), (iv), (v), (vi), (vii), (viii) and (ix), wherein R³, R⁴, R⁵ and R⁶ are the same or different and each mean a hydrogen atom or a monovalent group, R³ and R⁴ may be bonded together to form a ring, and a group represented by the formula (iv) may be reversed from left to right.

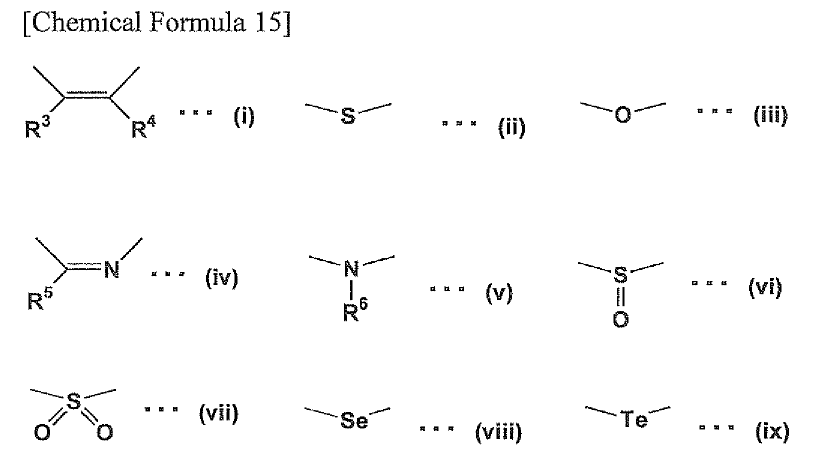

Z¹ is any of groups represented by formulas (i) to (ix), and is preferably any of groups represented by the formulas (ii), (iii), (v), (viii) and (ix), and more preferably any of groups represented by the formulas (ii), (iii) and (v). Among them a group represented by the formula (ii) is especially preferable. If a ring structure of a moiety including Z¹ is a thiophene ring, a furan ring or a pyrrole ring, especially a thiophene ring, the structure represents a characteristic electrical property, and expression of a nonconventional novel electrical characteristic may be expected.

In the formula (I-a), R¹ and R² are the same or different and are each a hydrogen atom, a halogen atom, or a monovalent group. R³, R⁴, R⁵ and R⁶ are the same or different and are each a hydrogen atom or a monovalent group. Examples of the halogen atom for R¹ and R² include a fluorine atom, a chlorine atom, a bromine atom and an iodine atom.

Examples of the monovalent group for R¹ to R⁶ include a group constituted of a linear or branched low molecular chain, a C3 to C60 monovalent cyclic group (which may be a monocycle or a condensed ring, a carbocycle or a heterocycle, saturated or unsaturated, and have a substituent or substituents), a saturated or unsaturated hydrocarbon group, a hydroxyl group, an alkoxy group, an alkanoyloxy group, an amino group, an oxyamino group, an alkylamino group, a dialkylamino group, an alkanoylamino group, a cyano group, a nitro group, a sulfo group, an alkyl group substituted by a halogen atom, an alkoxysulfonyl group (the alkoxy group may be substituted by a halogen atom or atoms), an alkylsulfonyl group (the alkyl group may be substituted by a halogen atom or atoms), a sulfamoyl group, an alkylsulfamoyl group, a carboxyl group, a carbamoyl group, an alkylcarbamoyl group, an alkanoyl group and an alkoxycarbonyl group.

Example of the saturated hydrocarbon group include a linear, branched or cyclic C1 to C20 alkyl group; and a linear, branched or cyclic C1 to C12 alkyl group is preferable. Examples of the alkyl group include a methyl group, an ethyl group, an n-propyl group, an iso-propyl group, an n-butyl group, an iso-butyl group, a tert-butyl group, a 3-methylbutyl group, a pentyl group, a hexyl group, a 2-ethylhexyl group, a heptyl group, an octyl group, a nonyl group, a decyl group, a lauryl group, a cyclopropyl group, a cyclobutyl group, a cyclopentyl group, a cyclohexyl group, a cycloheptyl group, a cyclooctyl group, a cyclononyl group, and a cyclododecyl group. Further, as examples of an alkyl group in a group containing the alkyl group in its structure (e.g. an alkoxy group, an alkylamino group, and an alkoxycarbonyl group), the same groups as above may be named.

Examples of the unsaturated hydrocarbon group include a vinyl group, a 1-propenyl group, an allyl group, a propargyl group, an isopropenyl group, a 1-butenyl group, and a 2-butenyl group.

Examples of the alkanoyl group include a formyl group, an acetyl group, a propionyl group, an isobutyryl group, a valeryl group, and an isovaleryl group. Further, as examples of an alkanoyl group in a group containing the alkanoyl group in its structure (e.g. an alkanoyloxy group, and an alkanoylamino group), the same groups as above may be named. The C1 alkanoyl group means herein a formyl group, and a group containing the alkanoyl group in its structure means identically.

For R¹ and R² among those described above, a hydrogen atom, a fluorine atom, a C1 to C20 alkyl group, a C1 to C20 fluoroalkyl group, a C1 to C20 alkoxy group, and a C1 to C20 fluoroalkoxy group are preferable; and a hydrogen atom, a fluorine atom, a C1 to C20 alkyl group, and a C1 to C20 fluoroalkyl group are more preferable.

From the viewpoint of lowering a LUMO level of a polymer and improving a charge transport property, at least one of R¹ and R² is preferably a group represented by formula (III).

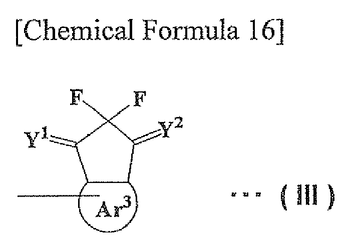

In the formula (III) Ar³ means a trivalent aromatic hydrocarbon group which may have a substituent or substituents, or a trivalent heterocyclic group which may have a substituent or substituents, and Y¹ and Y² are the same or different and each mean an oxygen atom, a sulfur atom, or a group represented by formula (a).

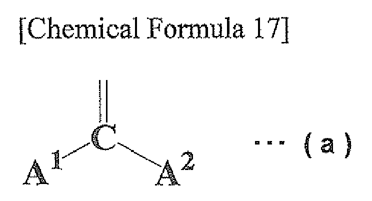

In the formula (a) A¹ and A² are the same or different and each mean a hydrogen atom, a halogen atom, or a monovalent group, and at least one of A¹ and A² is an electron-withdrawing group.

A trivalent aromatic hydrocarbon group as Ar³ in the formula (III) means a residual atomic group derived by removing 3 hydrogen atoms from a benzene ring or a condensed ring, and is preferably C6 to C60, and more preferably C6 to C20. As examples of the condensed ring, the same described above with respect to Ar⁰ may be named. As a trivalent aromatic hydrocarbon group, a residual atomic group derived by removing 3 hydrogen atoms from a benzene ring or a fluorene ring is preferable. A trivalent aromatic hydrocarbon group may have a substituent or substituents, but in this case the number of carbon atoms of the substituent is not counted in the number of carbon atoms of the trivalent aromatic hydrocarbon group. Examples of the substituent include a halogen atom, a saturated or unsaturated hydrocarbon group, an aryl group, an alkoxy group, an aryloxy group, a monovalent heterocyclic group, an amino group, a nitro group, and a cyano group.

Similarly, a trivalent heterocyclic group means a residual atomic group derived by removing 3 hydrogen atoms from a heterocyclic compound, and is preferably C3 to C60, and more preferably C3 to C20. As examples of a heterocyclic compound, the same described above with respect to Ar⁰ may be named. As a trivalent heterocyclic group, a residual atomic group derived by removing 2 hydrogen atoms from thiophene or thienothiophene is preferable. A trivalent heterocyclic group may have further a substituent, but in this case the number of carbon atoms of a substituent is not counted in the number of carbon atoms of the trivalent heterocyclic group. Example of the substituent include a halogen atom, a saturated or unsaturated hydrocarbon group, an aryl group, an alkoxy group, an aryloxy group, a monovalent heterocyclic group, an amino group, a nitro group, and a cyano group.

As examples of a halogen atom and a monovalent group for A¹ and A² in the formula (a), the same groups described above with respect to R¹ and R² may be named. Examples of an electron-withdrawing group include a cyano group, a nitro group, an aldehyde group, an acyl group, an alkoxycarbonyl group, a carboxyl group, a hydroxyl group, and a halogen atom; and a cyano group, a nitro group, and a halogen atom are preferable, and a cyano group is especially preferable. By using an electron-withdrawing group for at least one of A¹ and A², a LUMO can be lowered further.

As a group represented by the formula (III), especially a group represented by formula (IV) is preferable.

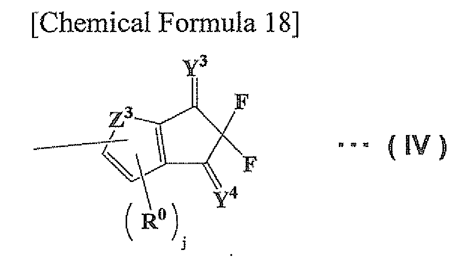

In the formula Y³ and Y⁴ are the same or different and are each an oxygen atom, a sulfur atom, or a group represented by the formula (a), and is preferably an oxygen atom. R⁰ means a hydrogen atom or a monovalent group, and j is an integer from 1 to the number of sites that can be substituted in a ring that R⁰ is bonded to. If a plurality of R⁰ is present, the plurality of R⁰ may be the same or different. Z³ means any of groups represented by formulas (xxi) to (xxix), wherein R¹³ , R¹⁴, R¹⁵ and R¹⁶ are the same or different and each mean a hydrogen atom, or a monovalent group, R¹³ and R¹⁴ may be bonded together to form a ring, and a group represented by the formula (xxiv) may be reversed from left to right.

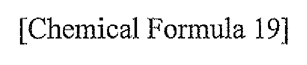

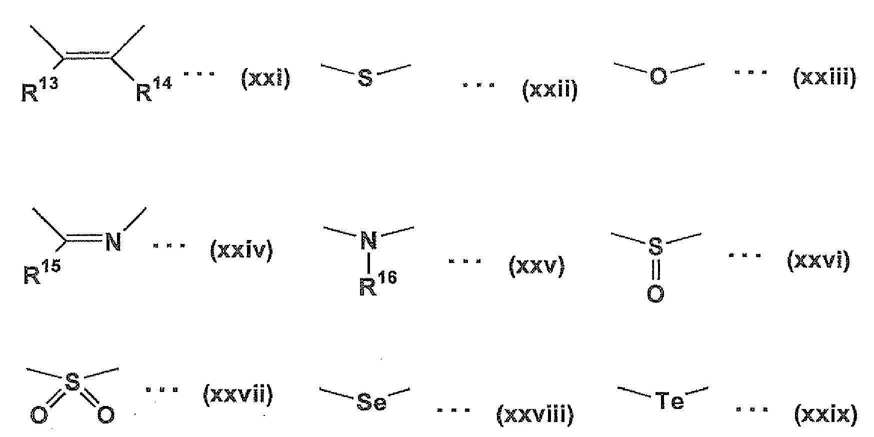

As Z³ in the formula (IV), a group represented by any of the formulas (xxii), (xxiii), (xxv), (xxviii) and (xxix) is preferable, a group represented by any of the formulas (xxii), (xxiii) and (xxv) is more preferable, and the group represented by the formula (xxii) is further preferable. If a ring including Z³ is a thiophene ring, a furan ring and a pyrrole ring, especially a thiophene ring, the structure represents a characteristic electrical property, and expression of a nonconventional novel electrical characteristic may be expected.

As a monovalent group for R⁰, and R¹³ to R¹⁶, the same groups as the monovalent groups named with respect to R¹ and R² can be applied.

By the presence of a group represented by the formula (III) (preferably a group represented by the formula (IV)) including an electron-withdrawing group as a group represented by R¹ or R² in the formula (I-a), the electron-withdrawing groups can interact each other intermolecularly more easily. As the result a polymer can function as an organic n-type semiconductor superior in a charge transport property.

In the formula (I-a) Ar¹ and Ar² are the same or different and are each a C6 or higher divalent aromatic hydrocarbon group, or a C4 or higher divalent heterocyclic group, and may have a substituent or substituents.

The divalent aromatic hydrocarbon group represented by Ar¹ or Ar² means a residual atomic group derived by removing 2 hydrogen atoms from a benzene ring or a condensed ring, and is preferably C6 to C60, more preferably C6 to C20. Examples of the condensed ring include a naphthalene ring, an anthracene ring, a tetracene ring, a pentacene ring, a pyrene ring, a perylene ring, and a fluorene ring. Among them as a divalent aromatic hydrocarbon group is preferable a residual atomic group derived by removing 2 hydrogen atoms from a benzene ring, a pentacene ring, a pyrene ring, or a fluorene ring. In this case, the number of carbon atoms of the substituent is not counted in the number of carbon atoms of the divalent aromatic hydrocarbon group. Examples of the substituent include a halogen atom, a saturated or unsaturated hydrocarbon group, an aryl group, an alkoxy group, an aryloxy group, a monovalent heterocyclic group, an amino group, a nitro group, an a cyano group.

Meanwhile, a divalent heterocyclic group represented by Ar¹ or Ar² means a residual atomic group derived by removing 2 hydrogen atoms from a heterocyclic compound, and is preferably C4 to C60, more preferably C4 to C20. The term "a heterocyclic compound" here means an organic compound having a cyclic structure, which includes not only carbon atoms as constituting elements of the ring, but also a heteroatom, such as oxygen, sulfur, nitrogen, phosphorus, boron, and silicon, in the ring.

Examples of the divalent heterocyclic group include residual atomic groups derived by removing 2 hydrogen atoms from thiophene, thienothiophene, dithienothiophene, thiazole, pyrrole, pyridine, and pyrimidine, and residual atomic groups derived by removing 2 hydrogen atoms from thiophene, thienothiophene, and thiazole are preferable. In this case, the number of carbon atoms of a substituent is not counted in the number of carbon atoms of the divalent heterocyclic group. Examples of the substituent include a halogen atom, a saturated or unsaturated hydrocarbon group, an aryl group, an alkoxy group, an aryloxy group, a monovalent heterocyclic group, an amino group, a nitro group, and a cyano group.

Especially, as Ar¹ and Ar² a group represented by formula (II) is preferable.

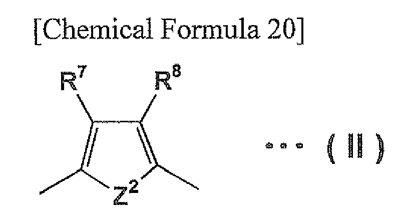

In the formula, R⁷ and R⁸ are the same or different and each mean a hydrogen atom or a monovalent group, and Z² means any of groups represented by formulas (xi), (xii), (xiii), (xiv), (xv), (xvi), (xvii), (xviii) and (xix), wherein R⁹, R¹⁰ , R¹¹ and R¹² are the same or different and each mean a hydrogen atom or a monovalent group, R⁹ and R¹⁰ may be bonded together to form a ring, and a group represented by the formula (xiv) may be reversed from left to right.

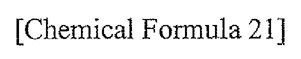

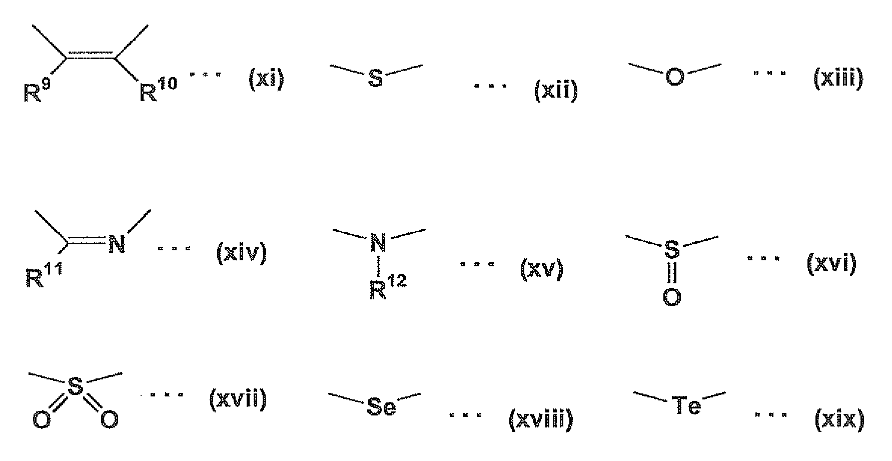

Z² in the formula (II) is preferably a group represented by any of the formulas (xii), (xiii), (xv), (xviii) and (xix), more preferably a group represented by any of the formulas(xii), (xiii) and (xv), and further preferably a group represented by the formula (xii). If a ring of a moiety including Z² is a thiophene ring, a furan ring or a pyrrole ring, especially a thiophene ring, a characteristic electrical property is exhibited, and expression of a nonconventional novel electrical characteristic may be expected.

As a monovalent group for R⁷ to R¹², the same groups as the monovalent groups named with respect to R¹ and R² can be applied.

A polymer of the present embodiment requires only to have a repeating unit represented by the formula (I), preferably a repeating unit represented by the formula (I-a), as its repeating unit, and it may include 1 kind or 2 or more kinds of the repeating units.

Further, the polymer may have 1 kind or 2 or more kinds of other repeating units than the formula (I) (preferably, formula (I-a)). As other repeating units than the formula (I) (preferably, formula (I-a)) a repeating unit represented by formula (V) is appropriate. Presence of an additional repeating unit represented by the formula (V) can enable a better control of solubility, or a mechanical, thermal or electronic property of the polymer. In this case, 2 or more kinds of repeating units represented by the formula (V) also can be included.

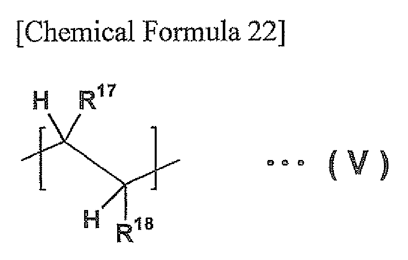

In the formula (V) R¹⁷ and R¹⁸ are the same or different and each mean a hydrogen atom, a halogen atom, or a monovalent group. As the monovalent group, the same groups as described above can be applied. As R¹⁷ and R¹⁸ a hydrogen atom, and an alkyl group are preferable.

If a repeating unit represented by the formula (I) (preferably formula (I-a)) and a repeating unit represented by the formula (V) are used in combination, the ratio of the former / the latter is preferably 100 mol / 10 to 1000 mol, more preferably, 100 mol / 25 to 400 mol, and further preferably 100 mol / 50 to 200 mol.

As for the afore-described polymer, those having repeating units represented by formulas (VI) to (X), (IX-1), and (X-1) are appropriate. The polymers are especially good at a charge transport property.

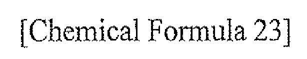

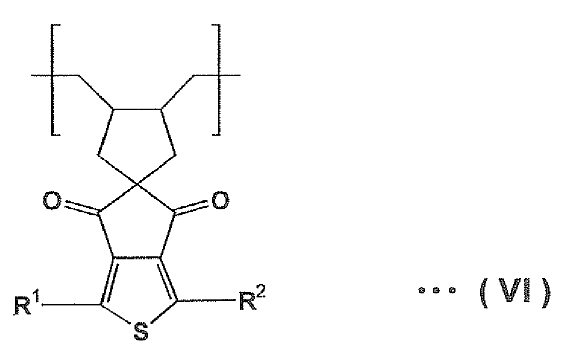

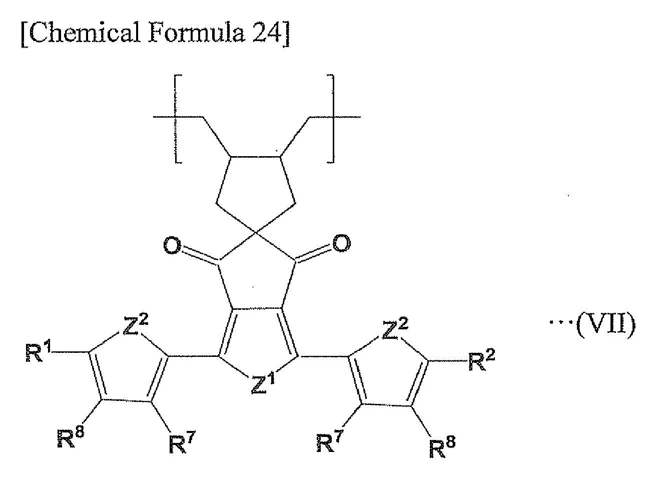

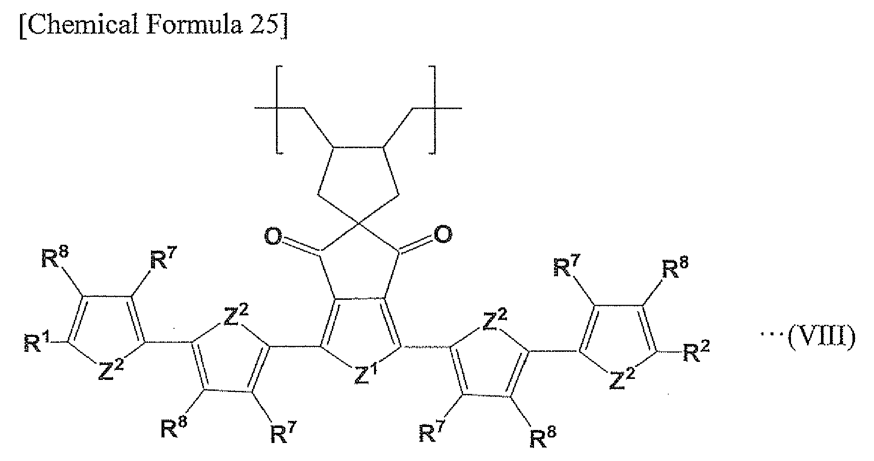

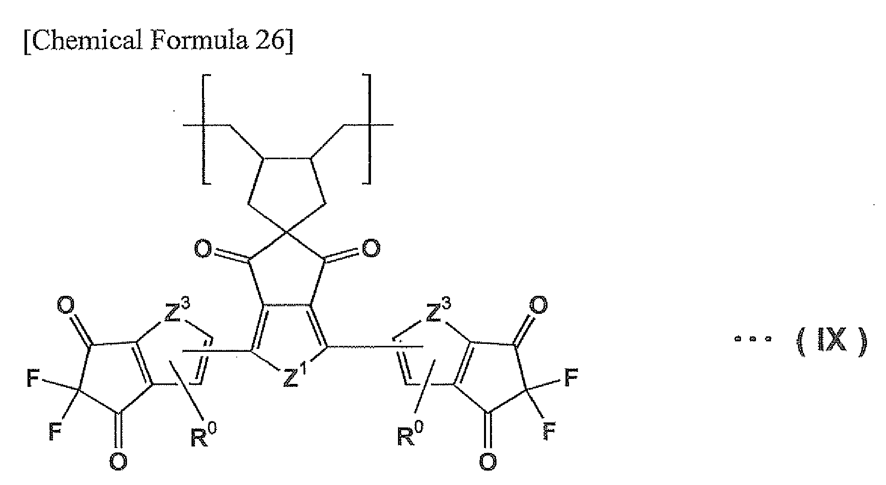

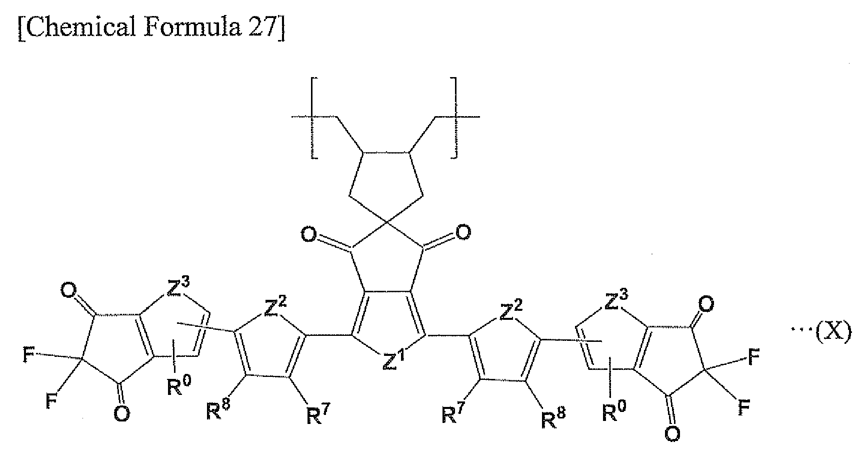

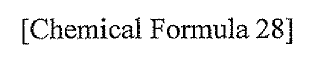

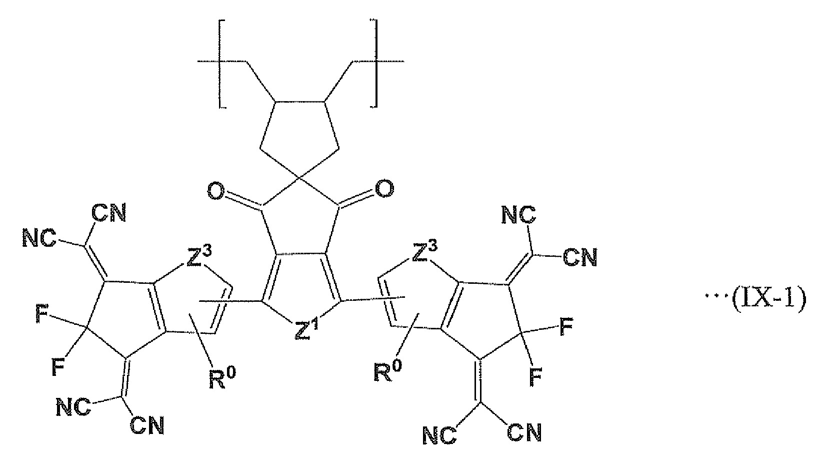

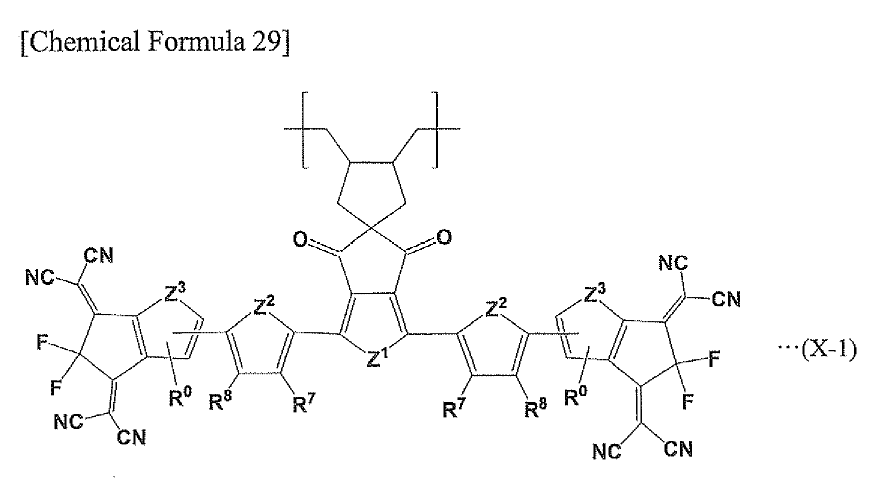

In the formulas all R⁰, R¹, R², R⁷, R⁸, Z¹, Z² and Z³ have the same meanings as described above. It should be noted that if a plurality of groups expressed by the same reference sign is present in a molecule, the groups expressed by the same reference sign may be the same or different.

Meanwhile, when a polymer according to the present embodiment is used as an organic thin film, if a polymerization reactive group remains at the end, it may sometimes reduce properties or durability of a produced organic thin-film element. If such a risk is foreseen, the polymerization reactive group may be protected by a stable group.

As the polymer those represented by formulas (1) to (9) are especially appropriate. Such polymers have a low LUMO, and are superior in a charge transport property, as well as very superior in solubility in a solvent.

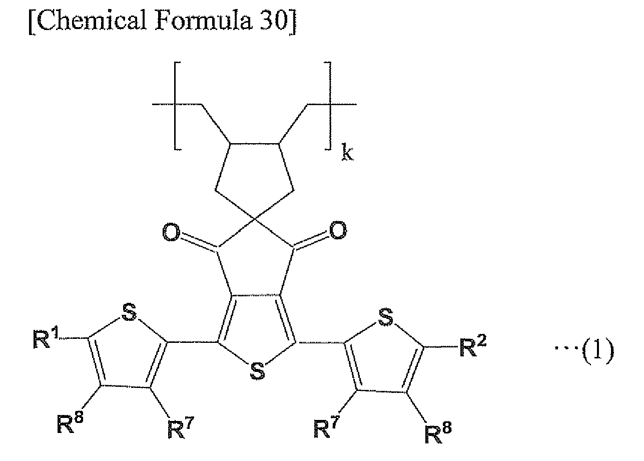

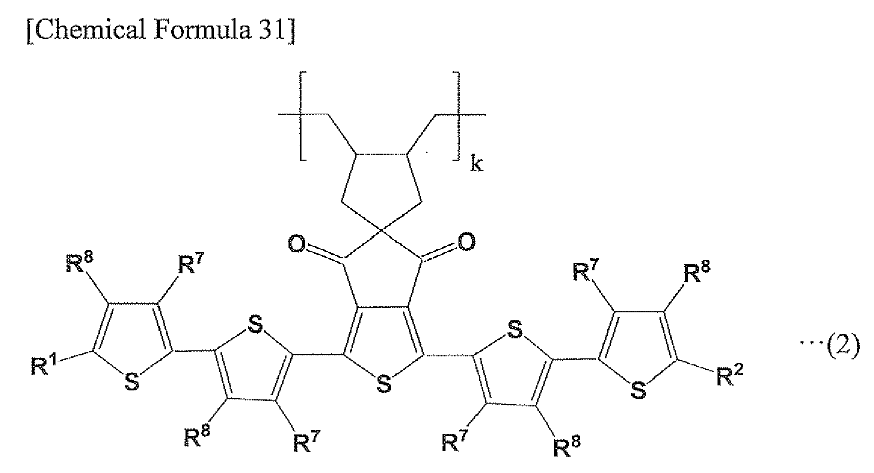

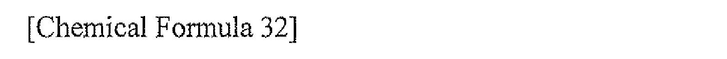

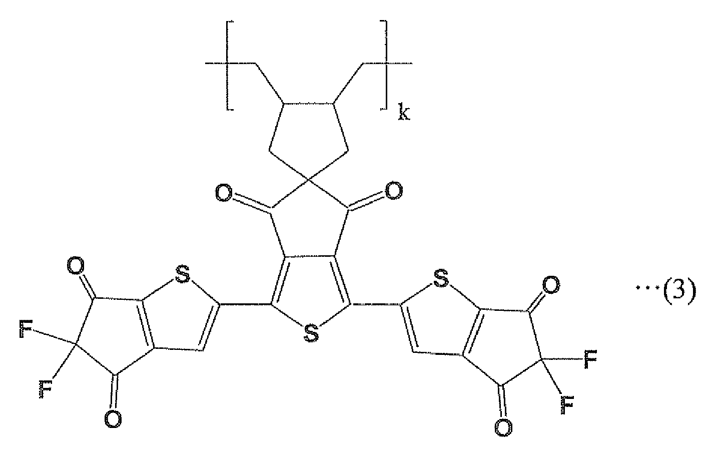

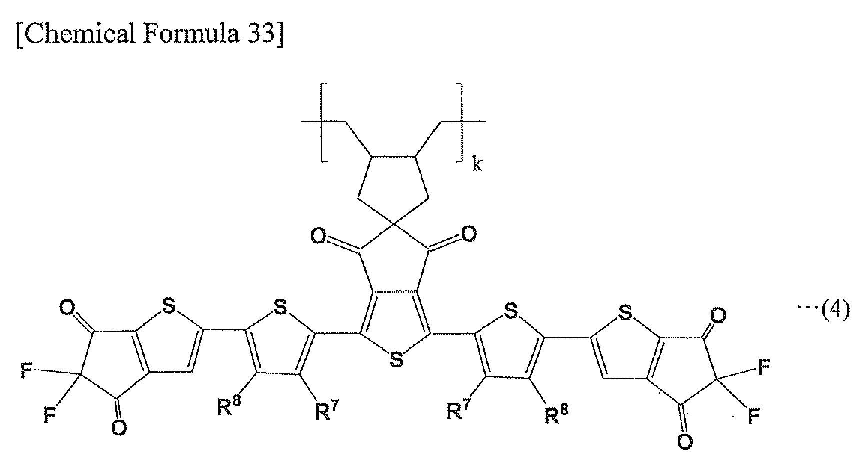

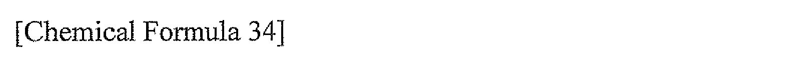

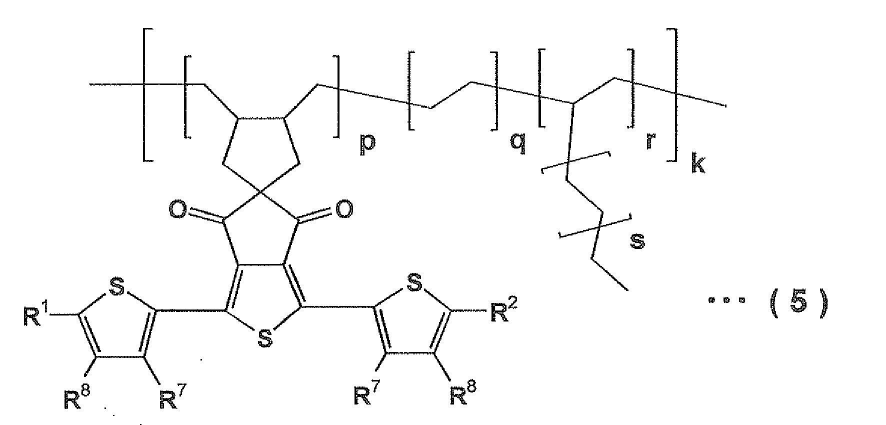

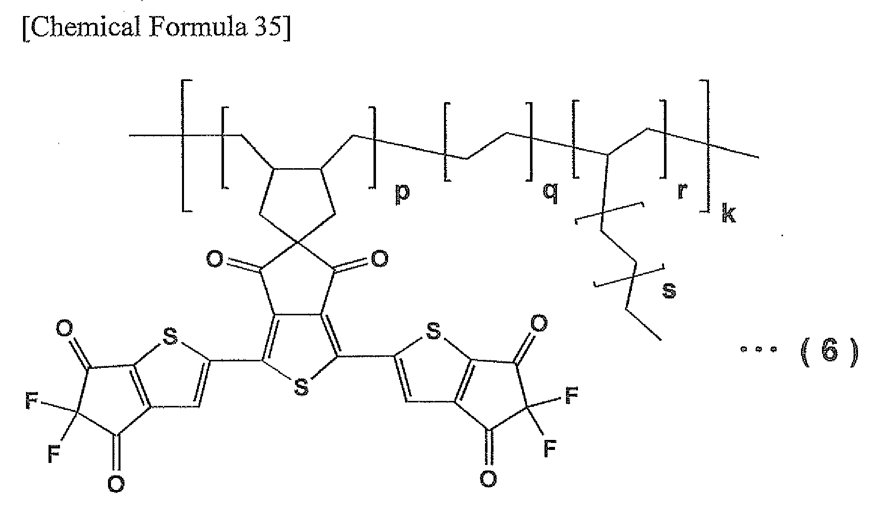

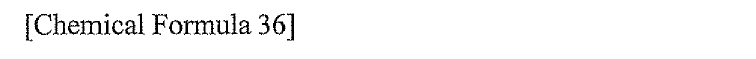

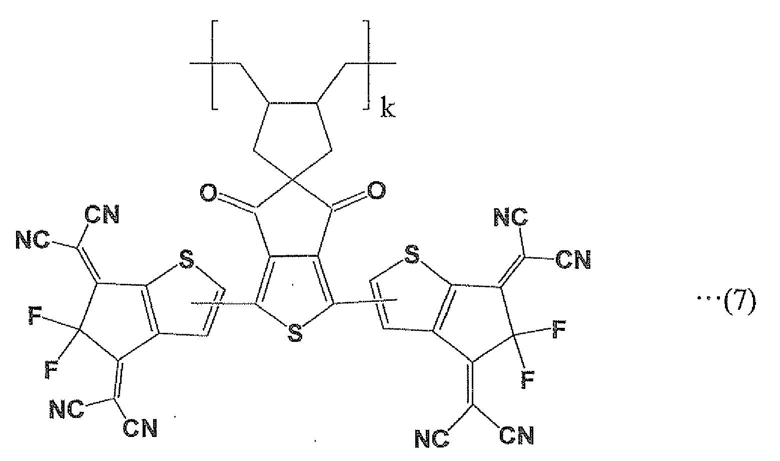

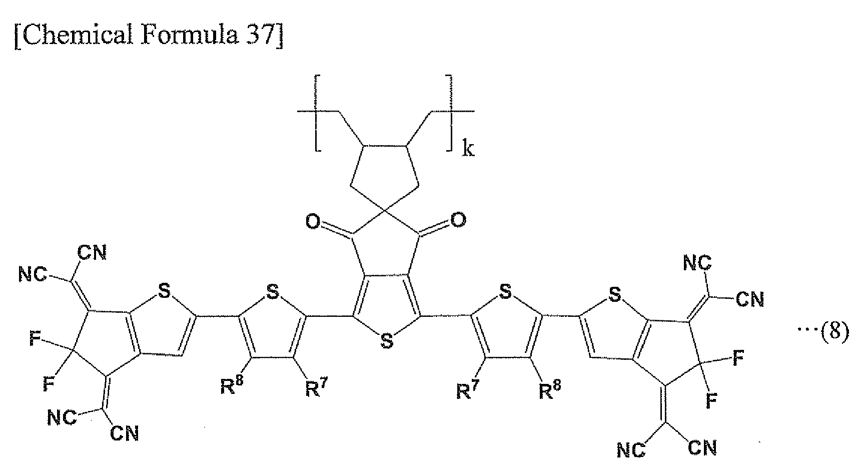

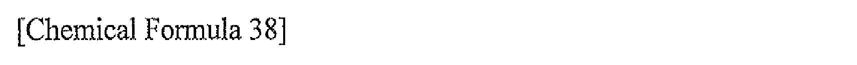

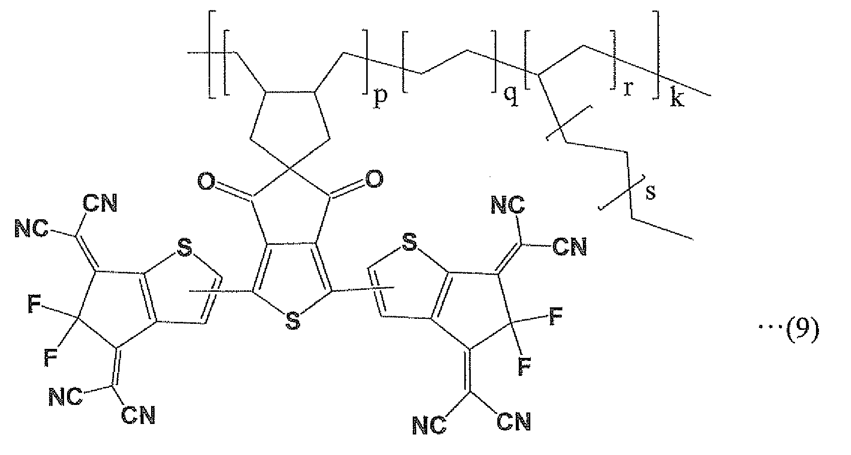

In the formulas all R¹, R², R⁷ and R⁸ have the same meanings as described above. If a plurality of the groups is present in a molecule, the groups expressed by the same reference sign may be the same or different. p means an integer of 1 to 20, and q, r and s, the same or different, mean an integer of 0 to 20. k means the degree of polymerization of a polymer, and can be selected appropriately in accordance with a method for forming an organic thin film using the polymer. If an organic thin film is formed by using a method of coating a solution of the polymer dissolved in an organic solvent, k is preferably an integer of 3 to 500, more preferably an integer of 6 to 300, and further preferably an integer of 20 to 200. It should be noted that from the viewpoint of attaining good homogeneity of the thin film when the film is formed by coating, a number average molecular weight of a polymer according to the present invention reduced to polystyrene is preferably 1×10³ to 1×10⁷, and more preferably 1×10⁴ to 1×10⁶.

### [Method for producing polymer]

Next, a preferred embodiment with respect to a method for producing a polymer will be described.

Although a polymer may be produced by any method, the following method for producing is especially appropriate. Preferably, for example, monomers represented by the formulas (XI) and (XII) are prepared as starting compounds, which are then reacted to produce a polymer. By this way, a polymer having a repeating unit represented by the formula (I-a) and a repeating unit represented by the formula (V) can be obtained adequately. This method for producing is merely an example, and the structure, the kind or the like of a starting compound may be altered appropriately in accordance with the aimed structure of a polymer.

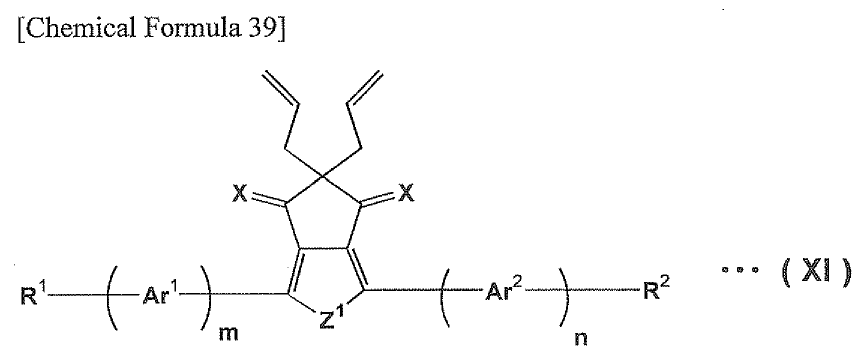

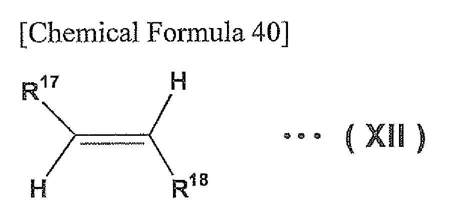

In the formulas, all Z¹, Ar¹, Ar², X, R¹, R², R¹⁷, R¹⁸, m and n have the same meanings as described above.

As a method for reacting a monomer represented by the formula (XI) and a monomer represented by the formula (XII) is a method described in the Journal of American Chemical Society, vol. 1.28 (2006), p. 3510 can be applied. More specifically, an example is a method, by which monomers having a nonconjugated diene are reacted to cause cyclopolymerization in the presence of a transition metal complex catalyst. As the transition metal complex catalyst, palladium diimine complex-tetraaryl borate, etc. can be applied. The reaction time is preferably 0.5 to 150 hours. The reaction temperature is preferably between -10°C and the boiling point of a solvent, and more preferably between 20 and 70°C. Further, as a palladium diimine complex is preferable [N,N'-1,2-acenaphthylenediylidene-bis(2,4,6-trimethylbenzenamine-κ-N)]chloromethyl-Palladium, or [N,N'-1,2-acenaphthylenediylidene-bis[2,6-bis(1-methylethyl)benzenam ine-κ-N)]]chloromethyl-Palladium.

If a polymer is used as a material for an organic thin-film element, its purity may occasionally affect an element property. Therefore it is preferable to purify a monomer as a stating compound prior to the reaction using a method, such as distillation, sublimation purification, and recrystallization, and then polymerize it. Further it is preferable to conduct a purification treatment, such as reprecipitation purification, Soxhlet extraction, and separation by chromatography, also after synthesis of a polymer.

Examples of a solvent to be used for the reaction include a saturated hydrocarbon, such as pentane, hexane, heptane, octane, and cyclohexane; an unsaturated hydrocarbon, such as benzene, toluene, ethylbenzene, and xylene; a halogenated saturated hydrocarbon, such as carbon tetrachloride, chloroform, dichloromethane, chlorobutane, bromobutane, chloropentane, bromopentane, chlorohexane, bromohexane, chlorocyclohexane, and bromocyclohexane; a halogenated unsaturated hydrocarbon, such as chlorobenzene, dichlorobenzene, and trichlorobenzene; an alcohol, such as methanol, ethanol, propanol, isopropanol, butanol, and t-butyl alcohol; a carboxylic acid, such as formic acid, acetic acid, and propionic acid; an ether, such as dimethyl ether, diethyl ether, methyl t-butyl ether, tetrahydrofuran, tetrahydropyran, and dioxane; and an inorganic acid, such as hydrochloric acid, hydrobromic acid, hydrofluoric acid, sulfuric acid, and nitric acid. One kind of the solvents may be used singly, or 2 or more kinds may be used in combination.

After the reaction the polymer can be recovered through conventional after-treatments, for example by quenching by water, extracting by an organic solvent, and distilling off the solvent. Isolation and purification of the polymer can be conducted by a method, such as separation by chromatography, and recrystallization.

### [Organic thin film]

Next an organic thin film with respect to a preferred embodiment will be described. An organic thin film according to the present embodiment includes a polymer having the above described characters.

A thickness of an organic thin film is preferably 1 nm to 100 µm, more preferably 2 nm to 1000 nm, further preferably 5 nm to 500 nm, and especially preferably 20 nm to 200 nm.

An organic thin film may include a kind of polymer singly, or include 2 or more kinds of polymers. Further, it may include in addition to polymer(s) according to the embodiment a hole transport material or an electron transport material as mixed, so as to improve an electron transport property or a hole transport property of the organic thin film.

As the hole transport material, a commonly known material may be used, and examples thereof include a pyrazoline derivative, an arylamine derivative, a stilbene derivative, a triaryldiamine derivative, oligothiophene and a derivative thereof, polyvinylcarbazole and a derivative thereof, polysilane and a derivative thereof, a polysiloxane derivative having an aromatic amine in a side chain or a main chain, polyaniline and a derivative thereof, polythiophene and a derivative thereof, polypyrrole and a derivative thereof, polyarylene vinylene and a derivative thereof, and polythienylene vinylene and a derivative thereof.

As an electron transport material, a commonly known material may be used, and examples thereof include an oxadiazole derivative, anthraquinodimethane and a derivative thereof, benzoquinone and a derivative thereof, naphthoquinone and a derivative thereof, anthraquinone and a derivative thereof, tetracyanoanthraquinodimethane and a derivative thereof, a fluorenane derivative, diphenyldicyanoethylene and a derivative thereof, a diphenoquinone derivative, or a metal complex of 8-hydroxyquinoline and a derivative thereof, polyquinoline and a derivative thereof, polyquinoxaline and a derivative thereof, polyfluorene and a derivative thereof, C60 or other fullerenes and a derivative thereof.

An organic thin film may include a charge generation material in order to generate an electric charge by absorbed light in the organic thin film. As the charge generation material, a commonly known material may be used, and examples thereof include an azo compound and a derivative thereof, a diazo compound and a derivative thereof, a metal-free phthalocyanine compound and a derivative thereof, a metal phthalocyanine compound and a derivative thereof, a perylene compound and a derivative thereof, a polycyclic quinone compound and a derivative thereof, a squarylium compound and a derivative thereof, an azlenium compound and a derivative thereof, a thiapyrylium compound and a derivative thereof, C60 or other fullerenes and a derivative thereof.

Further, an organic thin film may include another material required for exhibiting various functions. Examples of such other material include a sensitizer for intensifying a function to generate an electric charge by absorbed light, a stabilizer for improving stability, and a UV absorber for absorbing UV light.

Further, an organic thin film may include as a polymeric binder a polymeric compound material other than the polymer according to the embodiment to improve a mechanical property. As the polymeric binder, one that does not excessively interfere with an electron transport property or a hole transport property is preferable, and one that does not absorb visible light strongly is used preferably.

Examples of such a polymeric binder include poly(N-vinylcarbazole), polyaniline and a derivative thereof, polythiophene and a derivative thereof, poly(p-phenylene vinylene) and a derivative thereof, poly(2,5-thienylene vinylene) and a derivative thereof, polycarbonate, polyacrylate, polymethyl acrylate, polymethyl methacrylate, polystyrene, polyvinyl chloride, and polysiloxane.

Examples of a method for producing the organic thin film include a method of forming film from a solution containing a polymer as well as an electron transport material or a hole transport material, a polymeric binder, etc., which may be mixed according to need. Further, if a polymer has sublimating nature, a thin film can be formed by a vacuum deposition method.

As a solvent to be used for forming a film from a solution, such solvent as can dissolve a polymer, as well as an electron transport material, a hole transport material, a polymeric binder, etc. is acceptable. Examples of the solvent include an unsaturated hydrocarbon solvent, such as toluene, xylene, mesitylene, tetralin, decalin, bicyclohexyl, n-butylbenzene, sec-butylbenzene, and tert-butylbenzene; a halogenated saturated hydrocarbon solvent, such as carbon tetrachloride, chloroform, dichloromethane, dichloroethane, chlorobutane, bromobutane, chloropentane, bromopentane, chlorohexane, bromohexane, chlorocyclohexane, and bromocyclohexane; a halogenated unsaturated hydrocarbon solvent, such as chlorobenzene, dichlorobenzene, and trichlorobenzene; an ether solvent, such as tetrahydrofuran, and tetrahydropyran. A polymer can be dissolved in the solvent at 0.1 wt% or higher, subject to a structure or a molecular weight thereof.

As a method for forming a film using a solution can be used a coating method, such as a spin coating method, a casting method, a microgravure coating method, a gravure coating method, a bar coating method, a roll coating method, a wire bar coating method, a dip coating method, a spray coating method, a screen printing method, a flexo printing method, an offset printing method, an ink jet printing method, a dispenser printing method, a nozzle coating method, and a capillary coating method. Among others, a spin coating method, a flexo printing method, an ink jet printing method, a dispenser printing method, a nozzle coating method and a capillary coating method are preferable.

A process of producing an organic thin film may include a step of orienting a polymer. Since in an organic thin film whose polymer is oriented at the step, main chain molecules or side chain molecules align in one direction, electron mobility or hole mobility improves.

As a method for orienting a polymer, a method which is known as a method for orienting a liquid crystal can be used. Among others a rubbing method, a photo-orientation method, a shearing method (shearing stress application method), and a vertical dip coating method are simple, useful and user-friendly as an orientation technique, and a rubbing method and a shearing method are preferable.

### [Organic thin-film element].

Since an organic thin film according to the embodiment described above includes a polymer according to the afore-described embodiment, it has an excellent electric charge (electron or hole) transport property. Consequently, the organic thin film can transport efficiently an electron or a hole injected from an electrode or the like, or an electric charge generated by light absorption or the like, and is applicable to various electrical elements (organic thin-film elements) using an organic thin film. Since a polymer according to the afore-described embodiment also tends to be superior in environmental stability, by forming a thin film using the same, an organic thin-film element whose performance is stable even in the normal atmosphere can be produced. An example of an organic thin-film element will be described below.

### (Organic thin film transistor)

An organic thin film transistor with respect to a preferred embodiment will be described. An organic thin film transistor is required to have a structure provided with a source electrode, a drain electrode, an organic semiconductor layer, which forms a current pathway between the electrodes, and includes the afore-described polymer, (i.e. an active layer, the same applies hereinbelow), and a gate electrode to control the amount of current through the current pathway. Examples of the transistor include a field effect type, and a static induction type.

A field effect type organic thin film transistor comprises preferably a source electrode, a drain electrode, an organic semiconductor layer, which forms a current pathway between the electrodes, containing a polymer, a gate electrode to control the amount of current through the current pathway, and an insulating layer placed between the organic semiconductor layer and the gate electrode. Especially, it is preferable that a source electrode and a drain electrode be arranged in contact with an organic semiconductor layer containing a polymer, and that the gate electrode is provided sandwitching the insulating layer adjacent to the organic semiconductor layer.

It is preferable that a static induction type organic thin film transistor comprise a source electrode, a drain electrode, an organic semiconductor layer, which forms a current pathway between the electrodes, containing a polymer, and a gate electrode to control the amount of current through the current pathway, and that the gate electrode be placed in an organic semiconductor layer. Especially it is preferable that the source electrode, the drain electrode and the gate electrode placed in the organic semiconductor layer be arranged in contact with the organic semiconductor layer containing the polymer. There is no restriction on the structure of a gate electrode, as long as a structure makes it possible that a current pathway from a source electrode to a drain electrode is established and that the amount of current flowing through the current pathway can be controlled by applied voltage to the gate electrode, and, for example, an interdigital electrode can be named.

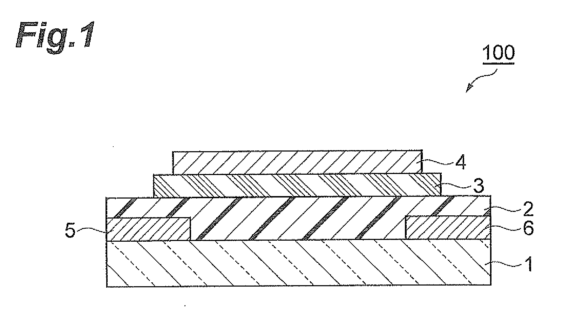

Figure 1 is a schematic sectional view of an organic thin film transistor (a field effect organic thin film transistor) according to the first embodiment. An organic thin film transistor 100 depicted in Figure 1 is provided with a substrate 1, a source electrode 5 and a drain electrode 6 formed on the substrate 1 with fixed spacing, an organic semiconductor layer 2 formed on the substrate 1 covering the source electrode 5 and the drain electrode 6, an insulating layer 3 formed on the organic semiconductor layer 2, and a gate electrode 4 formed on the insulating layer 3 covering a zone of the insulatimg layer 3 between the source electrode 5 and the drain electrode 6.

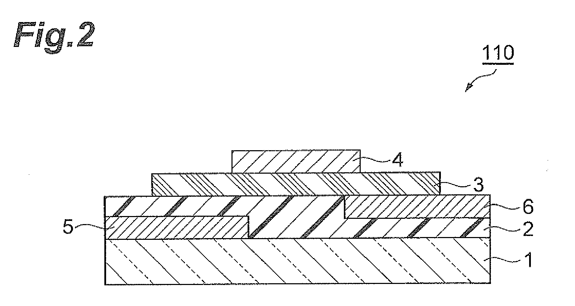

Figure 2 is a schematic sectional view of an organic thin film transistor (a field effect organic thin film transistor) according to the second embodiment. An organic thin film transistor 110 depicted in Figure 2 is provided with a substrate 1, a source electrode 5 formed on the substrate 1, an organic semiconductor layer 2 formed on the substrate 1 covering the source electrode 5, a drain electrode 6 formed on the organic semiconductor layer 2 with fixed spacing to the source electrode 5, an insulating layer 3 formed on the organic semiconductor layer 2 and the drain electrode 6, and a gate electrode 4 formed on the insulating layer 3 covering a zone of the insulating layer 3 between the source electrode 5 and the drain electrode 6.

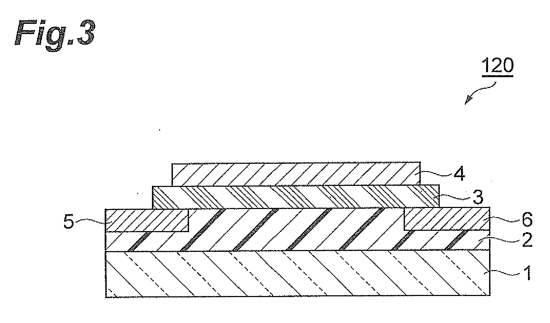

Figure 3 is a schematic sectional view of an organic thin film transistor (a field effect organic thin film transistor) according to the third embodiment. An organic thin film transistor 120 depicted in Figure 3 is provided with a substrate 1, an organic semiconductor layer 2 formed on the substrate 1, a source electrode 5 and a drain electrode 6 formed on the organic semiconductor layer 2 with fixed spacing, an insulating layer 3 formed on the organic semiconductor layer 2 covering partly the source electrode 5 and the drain electrode 6, and a gate electrode 4 formed on the insulating layer 3 covering partly each of a zone of the insulating layer 3, under which the source electrode 5 is formed, and a zone of the insulating layer 3, under which the drain electrode 6 is formed.

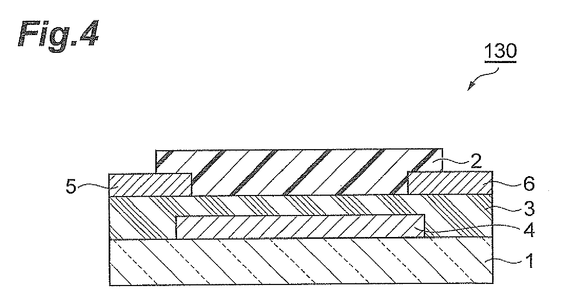

Figure 4 is a schematic sectional view of an organic thin film transistor (a field effect organic thin film transistor) according to the fourth embodiment. An organic thin film transistor 130 depicted in Figure 4 is provided with a substrate 1, a gate electrode 4 formed on the substrate 1, an insulating layer 3 formed on the substrate 1 covering the gate electrode 4, a source electrode 5 and a drain electrode 6 formed on the insulating layer 3 with fixed spacing covering partly zones of the insulating layer 3 under which the gate electrode 4 is formed, and an organic semiconductor layer 2 formed on the insulating layer 3 covering partly the source electrode 5 and the drain electrode 6.

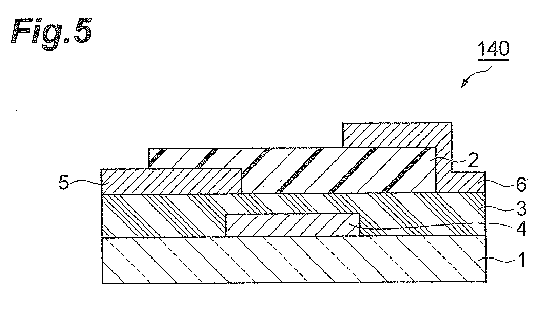

Figure 5 is a schematic sectional view of an organic thin film transistor (a field effect organic thin film transistor) according to the fifth embodiment. An organic thin film transistor 140 depicted in Figure 5 is provided with a substrate 1, a gate electrode 4 formed on the substrate 1, an insulating layer 3 formed on the substrate 1 covering the gate electrode 4, a source electrode 5 formed on the insulating layer 3 covering partly a zone of the insulating layer 3, under which the gate electrode 4 is formed, an organic semiconductor layer 2 formed on the insulating layer 3 covering partly the source electrode 5, and a drain electrode 6 formed on the insulating layer 3 with fixed spacing to the source electrode 5 covering partly a zone of the organic semiconductor layer 2.

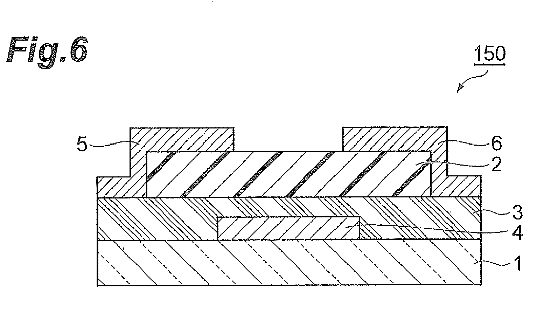

Figure 6 is a schematic sectional view of an organic thin film transistor (a field effect organic thin film transistor) according to the sixth embodiment. An organic thin film transistor 150 depicted in Figure 6 is provided with a substrate 1, a gate electrode 4 formed on the substrate 1, an insulating layer 3 formed on the substrate 1 covering the gate electrode 4, an organic semiconductor layer 2 formed covering partly a zone of the insulating layer 3, under which the gate electrode 4 is formed, a source electrode 5 formed on the insulating layer 3 covering partly a zone of the organic semiconductor layer 2, and a drain electrode 6 formed on the insulating layer 3 with fixed spacing to the source electrode 5 covering partly a zone of the organic semiconductor layer 2.

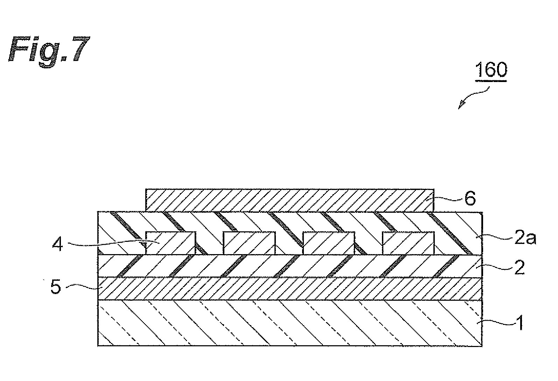

Figure 7 is a schematic sectional view of an organic thin film transistor (a static induction organic thin film transistor) according to the seventh embodiment. An organic thin film transistor 160 depicted in Figure 7 is provided with a substrate 1, a source electrode 5 formed on the substrate 1, an organic semiconductor layer 2 formed on the source electrode 5, a plurality of gate electrodes 4 formed on the organic semiconductor layer 2 with fixed spacing, an organic semiconductor layer 2a formed on the organic semiconductor layer 2 covering all the gate electrodes 4 (a material constituting the organic semiconductor layer 2a may be identical to or different from the organic semiconductor layer 2), and a drain electrode 6 formed on the organic semiconductor layer 2a.

With respect to an organic thin film transistor according to the first to seventh embodiment, an organic semiconductor layer 2 and/or an organic semiconductor layer 2a contains a polymer according to the present invention and constitutes a current channel between a source electrode 5 and a drain electrode 6. A gate electrode 4 controls the amount of current flowing through the current channel in the organic semiconductor layer 2 and/or the organic semiconductor layer 2a by means of applying voltage.

Such a field effect organic thin film transistor can be produced by a commonly known method, e.g. a method disclosed in Japanese Patent Application Laid-Open Publication No. 5-110069. While, a static induction organic thin film transistor can be produced by a commonly known method, e.g. a method disclosed in Japanese Patent Application Laid-Open Publication No. 2004-006476.

There is no restriction on a substrate 1 insofar as it does not interfere with characteristics of an organic thin film transistor, and a glass substrate, and a flexible film substrate or plastic substrate can be utilized.

For formation of an organic semiconductor layer 2, it is advantageous from a standpoint of production and preferable, to use a compound soluble in a solvent such as an organic solvent. Since the polymer according to the afore-described embodiment has high solubility in a solvent, an organic thin film constituting an organic semiconductor layer 2 can be formed satisfactorily by the afore-described method for producing an organic thin film.

There is no restriction on an insulating layer 3 adjacent to an organic semiconductor layer 2, insofar as it is an electrically highly insulating material, and a commonly known material can be used. Examples thereof include SiOx, SiNx, Ta₂O₅, polyimide, polyvinyl alcohol, polyvinylphenol, an organic glass and a photoresist. From the viewpoint of a lower voltage operation, a material having a high dielectric constant is preferable.

If an organic semiconductor layer 2 is formed on an insulating layer 3, in order to improve an interface property between the insulating layer 3 and the organic semiconductor layer 2, it is also possible to treat a surface of the insulating layer 3 for surface modification with a surface treatment agent such as a silane coupling agent, and then to form the organic semiconductor layer 2. Examples of the surface treatment agent include long chain alkylchlorosilanes, long chain alkylalkoxysilanes, fluorinated alkylchlorosilanes, fluorinated alkylalkoxysilanes, and a silyl amine compound such as hexamethyldisilazane. It is further possible to pretreat a surface of the insulating layer with ozone/UV, and O₂ plasma prior to the treatment with a surface treatment agent.

After production of an organic thin film transistor, it is preferable to form a protective coat over the organic thin film transistor to protect the element. By this means the organic thin film transistor can be blocked from the air to suppress reduction in characteristics of the organic thin film transistor. Further, by the protective coat, influence of a step for forming on the organic thin film transistor a display device to be driven by the transistor can be mitigated.

Examples of a method for forming a protective coat include a method of covering with a UV curing resin, a heat curing resin, or an inorganic SiONx film. To block the air effectively, it is preferable to conduct steps from the completion of the production of an organic thin film transistor to the formation of a protective coat without exposing to the air (e.g. in a dry nitrogen atmosphere, or in vacuum).

### (Solar cell)

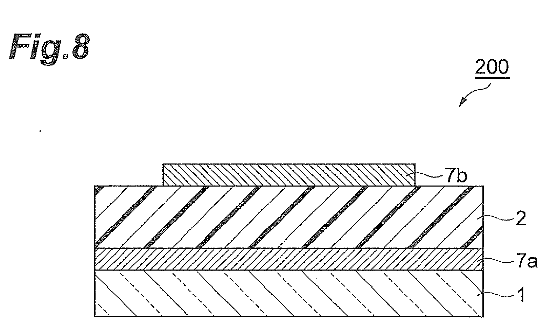

Next, application of an organic thin film according to the present invention to a solar cell will be described. Figure 8 is a schematic sectional view of a solar cell according to an embodiment. A solar cell 200 depicted in Figure 8 is provided with a substrate 1, the first electrode 7a formed on the substrate 1, an organic semiconductor layer 2 formed on the first electrode 7a, the layer being constituted of an organic thin film containing the polymer, and the second electrode 7b formed on the organic semiconductor layer 2.

In the solar cell according to the present embodiment, one of the first electrode 7a and the second electrode 7b uses a transparent or translucent electrode. As an electrode material a metal, such as aluminium, gold, silver, copper, an alkali metal, and an alkaline-earth metal, as well as a translucent film, and a transparent conductive film thereof can be used. To attain high open voltage, the respective electrodes are preferably selected so as to enlarge a difference of work functions. In an organic semiconductor layer 2 (an organic thin film) a charge generation agent, a sensitizer, etc. may be added and used in order to enhance photosensitivity. As a substrate 1 a silicon substrate, a glass substrate, a plastic substrate, etc. can be utilized.

### (Photosensor)

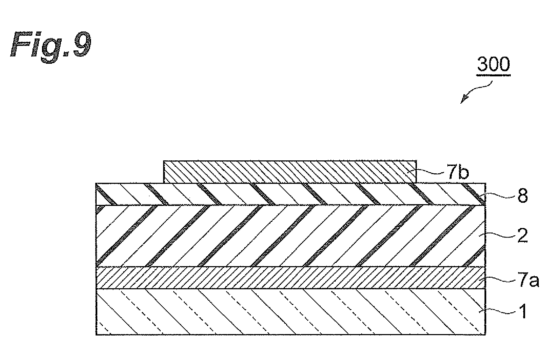

Next, application of an organic thin film according to the present invention to a photosensor will be described. Figure 9 is a schematic sectional view of a photosensor according to the first embodiment. A photosensor 300 depicted in Figure 9 is provided with a substrate 1, the first electrode 7a formed on the substrate 1, an organic semiconductor layer 2 formed on the first electrode 7a, the layer being constituted of an organic thin film containing the polymer, a charge generation layer 8 formed on the organic semiconductor layer 2 and the second electrode 7b formed on the charge generation layer 8.

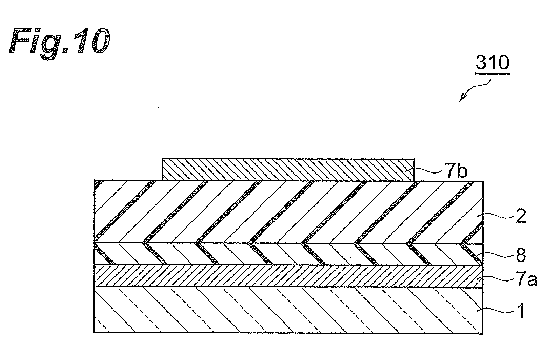

Figure 10 is a schematic sectional view of a photosensor according to the second embodiment. A photosensor 310 depicted in Figure 10 is provided with a substrate 1, the first electrode 7a formed on the substrate 1, a charge generation layer 8 formed on the first electrode 7a, an organic semiconductor layer 2 formed on the charge generation layer 8, the semiconductor layer being constituted of an organic thin film containing the polymer, and the second electrode 7b formed on the organic semiconductor layer 2.

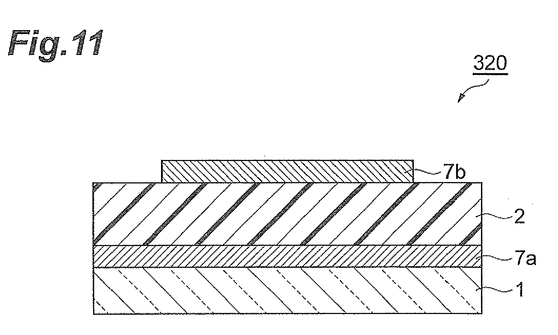

Figure 11 is a schematic sectional view of a photosensor according to the third embodiment. A photosensor 320 depicted in Figure 11 is provided with a substrate 1, the first electrode 7a formed on the substrate 1, an organic semiconductor layer 2 formed on the first electrode 7a, the layer being constituted of an organic thin film containing the polymer, and the second electrode 7b formed on the organic semiconductor layer 2.

In the photosensor according to the first to third embodiments, one of the first electrode 7a and the second electrode 7b uses a transparent or translucent electrode. A charge generation layer 8 is a layer, which generates an electric charge by absorbing light. As an electrode material a metal, such as aluminium, gold, silver, copper, an alkali metal, and an alkaline-earth metal, as well as a translucent film, and a transparent conductive film thereof can be used. In an organic semiconductor layer 2 (an organic thin film) a carrier generator, a sensitizer, etc. may be added and used in order to enhance photosensitivity. As a substrate 1. a silicon substrate, a glass substrate, a plastic substrate, etc. can be utilized.

### Examples

The present invention will be described more specifically below based on Examples and Comparative Examples, provided that the present invention be not limited to the following Examples, etc.

### (Measurement conditions)

Conditions of measurements carried out in the following Examples and Comparative Examples will be described.

A nuclear magnetic resonance (NMR) spectrum was measured by JMN-270 (trade name) by JEOL Ltd. (270 MHz in measuring ¹H), or by JMN LA-600 (trade name) by the same company (600 MHz in measuring ¹⁹F). Chemical shifts are expressed in parts per million (ppm). As an internal standard (0 ppm) tetramethylsilane (TMS) was used. A coupling constant (J) is expressed in Hz, and the abbreviations of s, d, t, q, m and br stand for a singlet, a doublet, a triplet, a quartet, a multiplet and a broad line, respectively.

A mass spectrometric analysis (MS) was carried out by GCMS-QP5050A (trade name) by Shimadzu Corp. according to an electron ionization (EI) method and a direct inlet (DI) method. As silica gel for column chromatography separation was used Silica gel 60N (trade name) by Kanto Chemical Co., Ltd. (40 to 50 µm). All the chemicals were JIS grades, and purchased from Wako Pure Chemical Industries, Ltd., Tokyo Chemical Industry Co., Ltd., Kanto Chemical Co., Ltd, Nacalai Tesque Inc., Sigma-Aldrich Japan K.K., or Daikin Industries Ltd.

### [Example 1]

A polymer D was produced after the following syntheses of compounds A, B and C.

### <Synthesis of compound A>

A starting material 1,3-dibromo-4H-cyclopenta[c]thiophene-4,6(5H)-dione (compound A represented by the following formula) was synthesized referring to Khanh, L.P., Dallemagne, P., Rault, S., Synlett, 1999, 9, 1450-1452.

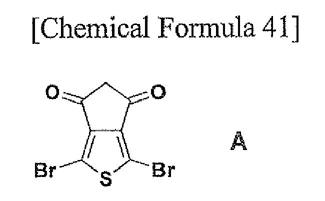

### <Synthesis of compound B>

The compound A (300 mg, 0.97 mmol) was charged into a 100 mL recovery flask and dissolved in THF (10 mL). After adding 1,8-diazabicyclo[5,4,0]-undec-7-ene (0.43 mL, 2.91 mmol), the mixture was stirred at 70°C for 15 min, allyl bromide (0.25 mL, 2.91 mmol) was further added, and the mixture was stirred at 70°C for 4 hours. After terminating the reaction by adding water, the mixture was extracted by ethyl acetate. An organic layer was washed by water, removed of the solvent by vacuum distillation to obtain a solid. The obtained solid was purified by column chromatography (silica gel, hexane : ethyl acetate = 10 : 1, by volume ratio) to obtain compound B (220 mg, yield 55%) represented by the following formula as a pale yellow solid.

Measurement results with respect to the compound B are as follows.

TLC Rf = 0.57 (10 / 1 = hexane / ethyl acetate, by volume ratio) ¹H NMR (400MHz, CDCl₃) δ 2.52 (d, 4H, J=7.6Hz), 5.01 (d, 2H, J=10.2), 5.08 (d, 2H, J=17.3Hz), 5.50-5.61 (m, 2H) MS (EI) m/z 390 (M⁺).

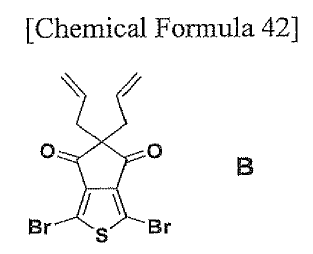

### <Synthesis of compound C>

The compound B (122 mg, 0.313 mmol) was charged into a test tube with a cap and dissolved in toluene. To this 2-tributylstannylthiophene (292 mg, 0.782 mmol) was added and under a nitrogen atmosphere tetrakis(triphenylphosphine)palladium (0) was added followed by stirring at 120°C for 12 hours. Thereafter column chromatography (silica gel, hexane: ethyl acetate = 5 : 1, by volume ratio), was conducted to obtain the compound C (93 mg, yield 75%), to be used as a starting compound, represented by the following formula as a yellow solid.

Measurement results with respect to the compound C are as follows.

TLC Rf= 0.50 (10 / 1 = hexane / ethyl acetate, by volume ratio) ¹H NMR (400MHz, CDCl₃) δ 2.57 (d, 4H, J=7.6Hz), 4.97 (d, 2H, J=11.7), 5.08 (d, 2H, J=16.8Hz), 5.58-5.68 (m, 2H), 7.14 (dd, 2H, J=3.6Hz, 5.1H), 7.45 (dd, J=1.2Hz, 5.1Hz) 8.12 (dd, J=1. Hz, 3.7 Hz) MS (EI) m/z 3 9 6 (M⁺).

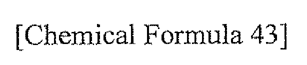

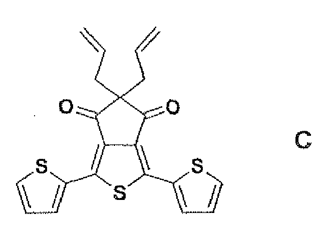

### <Synthesis of polymer D 1>

The compound C (60 mg, 0.151 mmol) was charged into a test tube with a cap and dissolved in dichloromethane. To this the compound E (21 mg, 0.0038 mmol) and the compound F (3.3 mg, 0.0038 mmol) represented by the following formulas were added followed by stirring at room temperature for 48 hours.

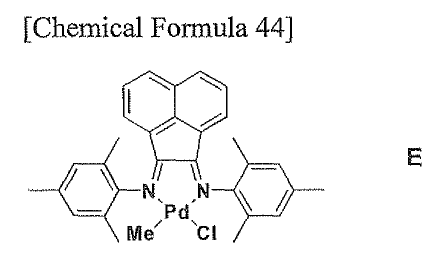

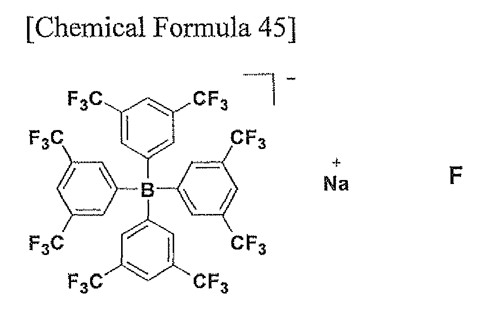

After removal of the solvent by vacuum distillation, a crude product was passed through a silica chromatography column (CHCl₃) and then purified by GPC (CHCl₃). As the result a polymer D (32 mg) represented by the following formula was obtained as a yellow solid. k in the following formula D means the degree of polymerization (the same applies hereinbelow). The polymer D had high solubility with respect to chloroform, dichloromethane and tetrahydrofuran.

A number average molecular weight reduced to polystyrene of the obtained polymer D was 3,100. Further, a reduction potential of the polymer D was -1.98 V indicating a low LUMO level, and an oxidation potential thereof was 0.90 V. Other measurement results of the polymer D were as follows.
¹H NMR (400MHz, CDCl₃) δ 0.88-1.33 (broad), 6.77-7.22 (broad), 7.26-7.50 (broad), 7.77-8.16 (broad)

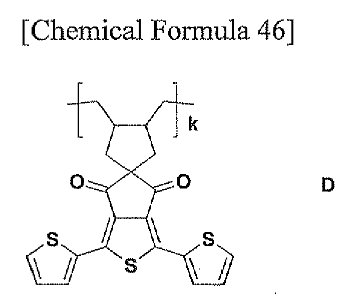

### [Example 2]

### <Synthesis of polymer D 2>

Synthesis of a polymer D was conducted identically with the synthesis of polymer D 1 according to Example 1, except that stirring was carried out at 40°C for 48 hours instead of at room temperature for 48 hours. As the result a polymer D, whose number average molecular weight reduced to polystyrene was 3,800, was obtained.

### [Example 3]

### <Synthesis of polymer D 3>

Synthesis of a polymer D was conducted identically with the synthesis of polymer D 1 according to Example 1, except that the compound M represented by the following formula instead of the compound E was used. As the result a polymer D, whose number average molecular weight reduced to polystyrene was 3,200, was obtained.

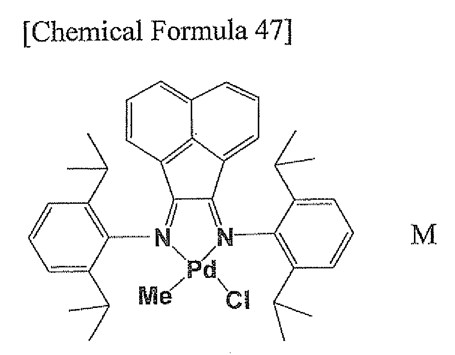

### [Example 4]

### <Synthesis of polymer D 4>

Synthesis of a polymer D was conducted identically with the synthesis of polymer D 3 according to Example 3, except that stirring was carried out at 40°C for 48 hours instead of at room temperature for 48 hours. As the result a polymer D, whose number average molecular weight reduced to polystyrene was 3,600, was obtained.

### [Example 5]

A polymer L was produced after the following syntheses of compounds G, H, J and K.

### <Synthesis of compound G>

The compound A (300 mg, 0.968 mmol) was charged in a 50 mL recovery flask and dissolved in benzene (20 mL). To this ethylene glycol (1.08 mL, 19.36 mmol), and p-toluenesulfonic acid monohydrate (17 mg, 0.0968 mmol) were charged and stirred at 100°C for 36 hours. Alter terminating the reaction by adding water, the mixture was extracted by ethyl acetate, followed by washing by water. After removal of the solvent by vacuum distillation, the extract was purified by column chromatography (silica gel, 3 / 1 = hexane / ethyl acetate, by volume ratio) to obtain the compound G (348 mg, yield 90%) represented by the following formula as a brown solid.

Measurement results of the compound G were as follows.
TLC Rf = 0.17 (3/1 = hexane / ethyl acetate, by volume ratio) ¹H NMR (400MHz, CDCl₃) δ 2.81 (s, 2H,), 4.05-4.13 (m, 2H), 4.23-4.31 (m, 2H)
MS (EI) m/z 398 (M⁺).

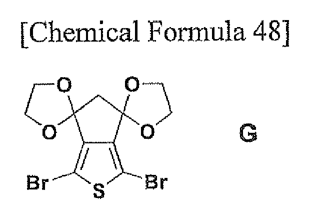

### <Synthesis of compound H>

The compound G (100 mg, 0.251 mmol) was charged in a 50 mL 2-necked recovery flask, and dissolved in THF. To this n-butyllithium (1.6 M hexane solution, 0.314 mL, 0.502 mmol) was added at -78°C. The mixture was stirred for 1 hour, to which tributyltin chloride (0.143 mL, 0.527 mmol) was added, and warmed up gradually to room temperature. The reaction was terminated by adding water after 2 hours, and the mixture was extracted by ethyl acetate. An extracted organic layer was washed by water and then dried over magnesium sulfate. Thereafter, after removal of the solvent by vacuum distillation, a crude product was purified by column chromatography (alumina, 10 / 1 = hexane / ethyl acetate, by volume ratio) to obtain the compound H (112 mg, yield 55%) represented by the following formula as a yellow liquid.

Measurement results of the compound H were as follows.

TLC Rf = 0.53 (10/1 = hexane / ethyl acetate, by volume ratio) ¹H NMR (400MHz, CDCl₃) δ 0.83-0.93 (m, 18H), 1.01-1.18 (m, 12H), 1.27-1.37 (m, 12H), 1.51-1.67 (m, 10-H), 1.46-1.63 (m, 12H), 2.65 (s, 2H), 3.97-4.03 (m, 2H), 4.06-4.12 (m, 2H)
MS (EI) m/z 818 (M⁺).

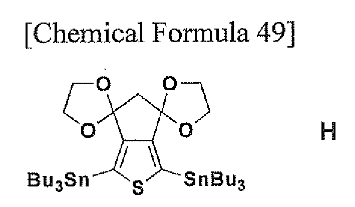

### <Synthesis of compound J>

The compound H, the compound represented by the following formula and tetrakis(triphenylphosphine)palladium (0) are charged in a test tube with a cap and dissolved in toluene. The mixture is stirred under heating, and then left cooling at room temperature. After removal of the solvent by vacuum distillation, a crude product is passed through silica column chromatography, and then purified by GPC (CHCl₃).

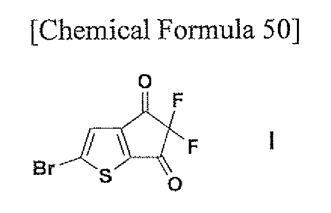

The obtained compound is charged in a recovery flask, dissolved in THF, to which concentrated sulfuric acid is added, and the mixture is stirred at room temperature. Next, the obtained reaction mixture is poured onto ice and extracted by ethyl acetate. Thereafter an organic layer is washed by a saturated aqueous solution of sodium hydrogencarbonate and water, and then dried over magnesium sulfate. After removal of the solvent by vacuum distillation, the obtained solid is purified by GPC (CHCl₃), and thus the compound J represented by the following formula can be obtained.

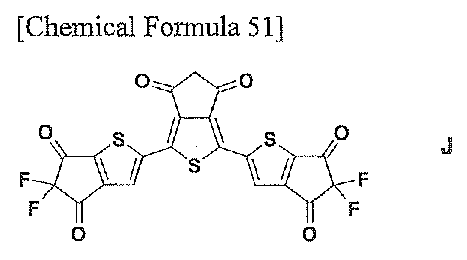

### <Synthesis of compound K>

The compound J is charged in a 100 mL recovery flask, and dissolved in THF. The mixture is added with 1,8-diazabicyclo[5,4,0]-undec-7-ene and stirred under heating, and then further added with allyl bromide and stirred under heating. After terminating the reaction by adding water, the mixture is extracted by ethyl acetate. An organic layer is washed by water, and removed of the solvent by vacuum distillation. An obtained solid is purified by column chromatography (silica gel), and thus the compound K, to be used as a starting compound, represented by the following formula can be obtained.

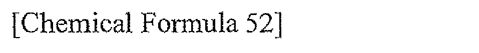

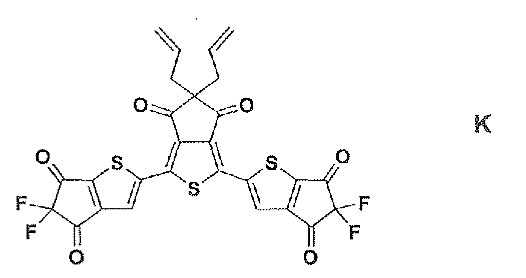

### <Synthesis of compound L>

The compound K is charged in a test tube with a cap, and dissolved in dichloromethane. The compound E and the compound F are added to the mixture, which is then stirred at room temperature for 48 hours. After removal of the solvent by vacuum distillation, a crude product is passed through silica column chromatography (CHCl₃), and then purified by GPC (CHCl₃), and thus the compound L represented by the following formula can be obtained.

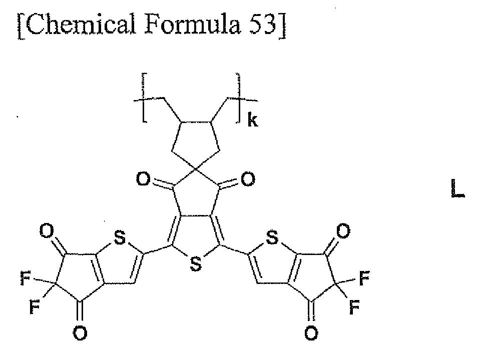

### [Example 6]

### <Production of organic thin film transistor and evaluation of transistor property thereof>

A low resistivity silicon wafer having a thermally-oxidized film (silicon dioxide film) (a structure to become a gate electrode/an insulating layer) is dipped in each of ethanol, distilled water, and acetone in the order mentioned, and then subjected to ultrasonic cleaning. Then the silicon wafer is subjected to UV-ozone cleaning to obtain a substrate having a hydrophilic surface. The substrate is dipped in hexamethyldisilazane / chloroform at room temperature, and cleaned by ultrasonic cleaning using chloroform to obtain a surface prepared substrate.

Next, a coating solution is prepared by dissolving the polymer D synthesized in Example 1 in chloroform. The solution is formed to a film by a spin coating method on the surface prepared substrate to form an organic thin film. An organic thin film transistor is produced by forming gold electrodes (source electrode, drain electrode) on the organic thin film by means of vacuum deposition using a metal mask.

By measuring the obtained organic thin film transistor with respect to an organic transistor characteristic by changing gate voltage Vg and source-drain voltage Vsd using a semiconductor parametric analyzer ("4200-SCS" (trade name), by Keithley Instruments Inc.), a good Id-Vg characteristic of an n-type semiconductor is obtained. This shows that a polymer according to the present invention has an excellent charge transport property.

### Reference Signs List

1 ... substrate, 2 ... organic semiconductor layer, 2a ... organic semiconductor layer, 3 ... insulating layer, 4 ... gate electrode, 5 ... source electrode, 6 ... drain electrode, 7a ... the first electrode, 7b ... the second electrode, 8 ... charge generation layer, 100 ... organic thin film transistor according to first embodiment, 110 ... organic thin film transistor according to second embodiment, 120 ... organic thin film transistor according to third embodiment, 130 ... organic thin film transistor according to fourth embodiment, 140 ... organic thin film transistor according to fifth embodiment, 150 ... organic thin film transistor according to sixth embodiment, 160 ... organic thin film transistor according to seventh embodiment, 200 ... solar cell according to embodiment, 300 ... photosensor according to first embodiment, 310 ... photosensor according to second embodiment, 320 ... photosensor according to third embodiment.

## Claims

1. A polymer having a repeating unit represented by formula (1); 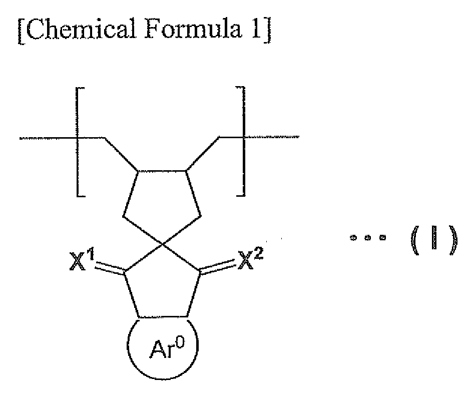 wherein Ar⁰ means an aromatic ring that may have a substituent or substituents, or a heterocycle that may have a substituent or substituents, and X¹ and X² are the same or different and each mean an oxygen atom or a sulfur atom.

2. The polymer according to claim 1, wherein the repeating unit represented by the formula (I) is a repeating unit represented by formula (I-a); 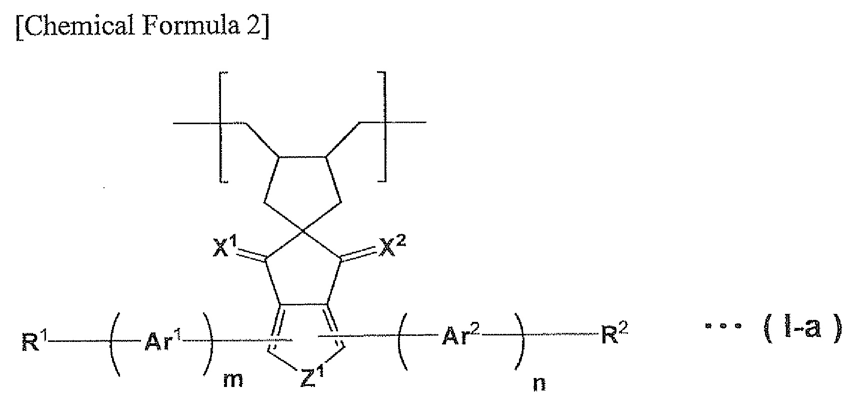 wherein X¹ and X² have the same meanings as defined in claim 1, Ar¹ and Ar² are the same or different and each mean a C6 or higher divalent aromatic hydrocarbon group that may have a substituent or substituents, or a C4 or higher divalent heterocyclic group that may have a substituent or substituents, and R¹ and R² are the same or different and each mean a hydrogen atom, a halogen atom, or a monovalent group; m and n are the same or different and are each an integer of 0 to 6; and Z¹ means any of groups represented by the following formulas (i), (ii), (iii), (iv), (v), (vi), (vii), (viii) and (ix); 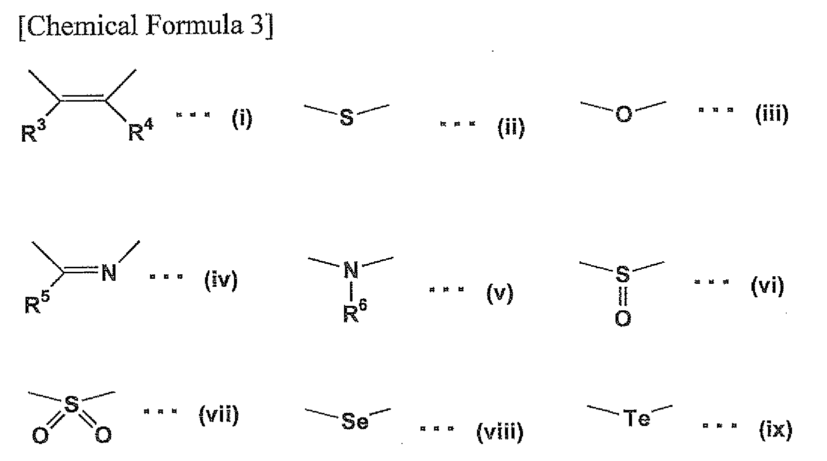 wherein R³, R⁴, R⁵ and R⁶ are the same or different and each mean a hydrogen atom or a monovalent group, R³ and R⁴ may be bonded together to form a ring, and a group represented by the formula (iv) may be reversed from left to right; and if a plurality of Ar¹ or Ar² is present, the plurality of Ar¹ or Ar² may be the same or different.

3. The polymer according to claim 2, wherein Ar¹ and Ar² are the same or different and is each a group represented by formula (II): 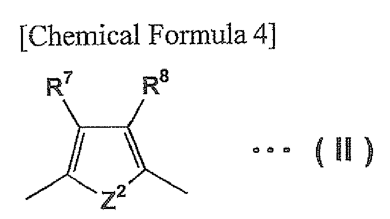 wherein R⁷ and R⁸ are the same or different and each mean a hydrogen atom or a monovalent group, and R⁷ and R⁸ may be bonded together to form a ring; Z² means any of groups represented by formulas (xi), (xii), (xiii), (xiv), (xv), (xvi), (xvii), (xviii) and (xix): 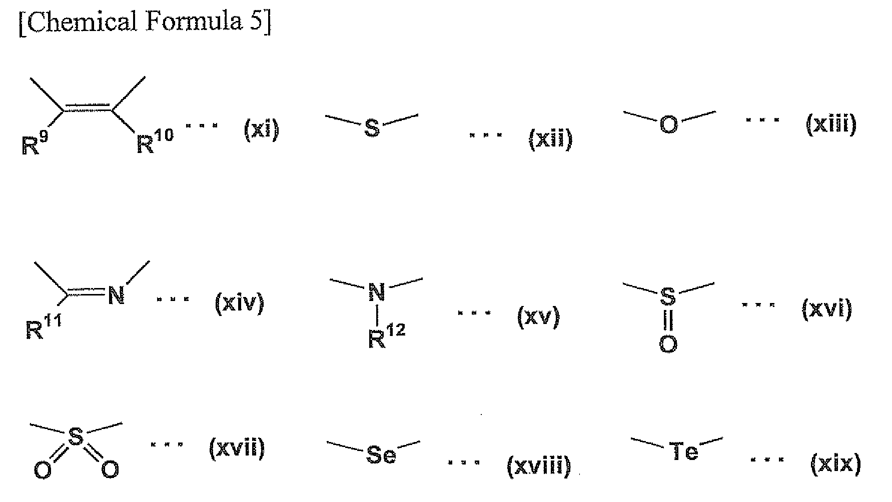 wherein R⁹, R¹⁰, R¹¹ and R¹² are the same or different and each mean a hydrogen atom or a monovalent group, R⁹ and R¹⁰ may be bonded together to form a ring, and a group represented by the formula (xiv) may be reversed from left to right.

4. The polymer according to claim 2 or 3, wherein the Z¹ is a group represented by the formula (ii).

5. The polymer according to claims 3 or 4, wherein the Z² is a group represented by the formula (xii).

6. The polymer according to any one of claims 2 to 5, wherein at least one of the R¹ and the R² is a group represented by formula (III); 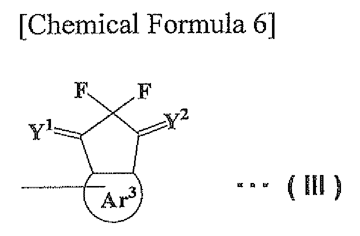 wherein Ar³ means a trivalent aromatic hydrocarbon group that may have a substituent or substituents, or a trivalent heterocyclic group that may have a substituent or substituents, and Y¹ and Y² are the same or different and each mean an oxygen atom, a sulfur atom, or a group represented by formula (a); 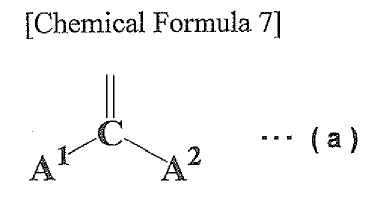 wherein A¹ and A² are the same or different and each mean a hydrogen atom, a halogen atom, or a monovalent group, and at least one of A¹ and A² is an electron-withdrawing group.

7. The polymer according to claim 6, wherein the group represented by the formula (III) is a group represented by formula (IV): 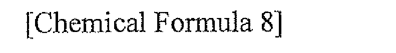 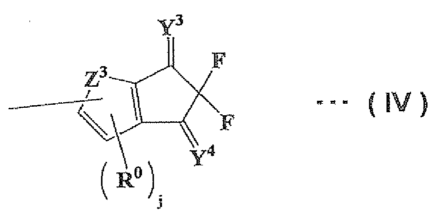 wherein Y³ and Y⁴ are the same or different and each mean an oxygen atom, a sulfur atom, or a group represented by the formula (a), R⁰ means a hydrogen atom or a monovalent group, and j is an integer from 1 to a number of sites that can be substituted in a ring that R⁰ is bonded to; if a plurality of R⁰ is present, R⁰ may be the same or different; and Z³ means any of groups represented by formulas (xxi), (xxii), (xxiii), (xxiv), (xxv), (xxvi), (xxvii), (xxviii) and (xxix): 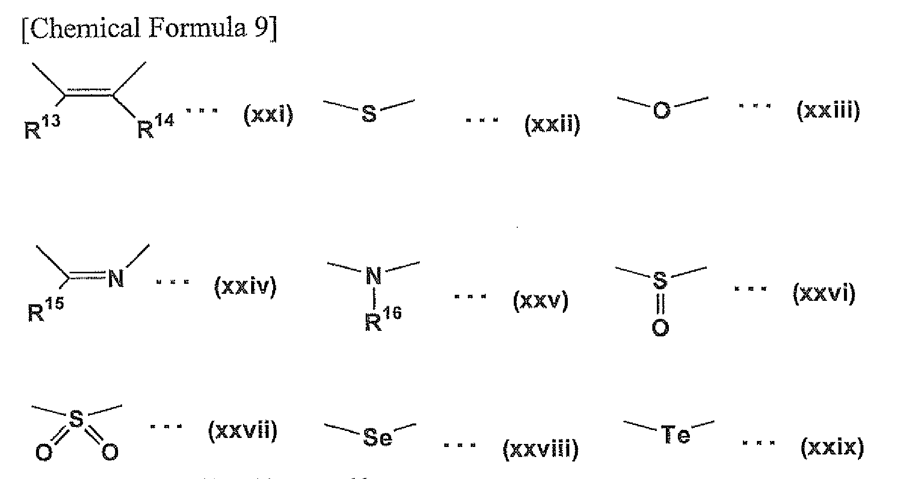 wherein R¹³, R¹⁴, R¹⁵ and R¹⁶ are the same or different and each mean a hydrogen atom, or a monovalent group, R¹³ and R¹⁴ may be bonded together to form a ring, and a group represented by the formula (xxiv) may be reversed from left to right.

8. A monomer represented by formula (XI); 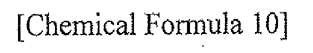 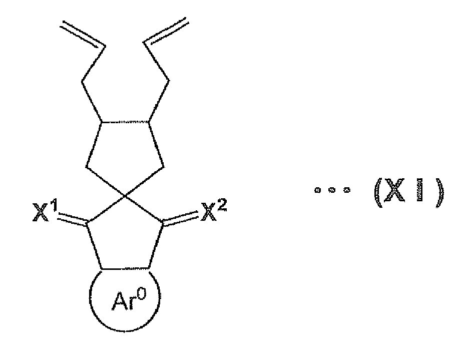 wherein Ar⁰ means an aromatic ring that may have a substituent or substituents, or a heterocycle that may have a substituent or substituents, and X¹ and X² are the same or different and each mean an oxygen atom or a sulfur atom.

9. A monomer represented by formula (XI-a): 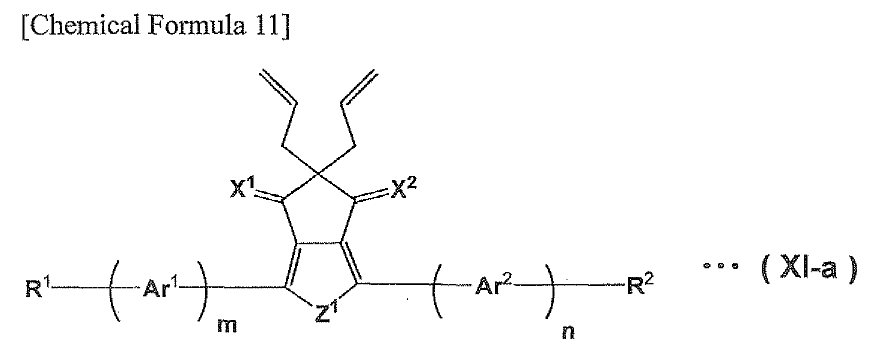 wherein Ar¹ and Ar² are the same or different and each mean a C6 or higher divalent aromatic hydrocarbon group that may have a substituent or substituents, or a C4 or higher divalent heterocyclic group that may have a substituent or substituents, R¹ and R² are the same or different and each mean a hydrogen atom, a halogen atom, or a monovalent group, and X¹ and X² are the same or different and each mean an oxygen atom or a sulfur atom; m and n are the same or different and are each an integer of 0 to 6; and Z¹ means any of the groups represented by formulas (i), (ii), (iii), (iv), (v), (vi), (vii), (viii) and (ix): 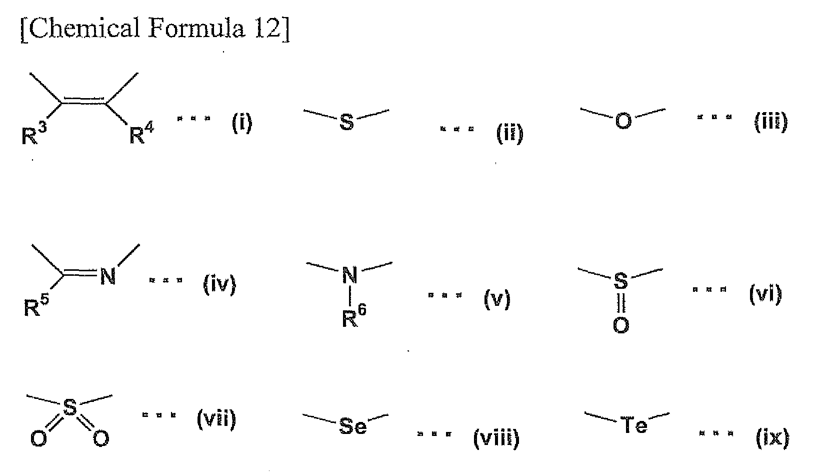 wherein R³, R⁴, R⁵ and R⁶ are the same or different and each mean a hydrogen atom or a monovalent group, R³ and R⁴ may be bonded together to form a ring, and a group represented by the formula (iv) may be reversed from left to right; and it should be noted that if a plurality of Ar¹ or Ar² is present, the plurality of Ar¹ or Ar² may be the same or different.

10. An organic thin film comprising the polymer according to any one of claims 1 to 7.

11. An organic thin-film element comprising the organic thin film according to claim 10.

12. An organic thin film transistor comprising a source electrode, a drain electrode, an organic semiconductor layer that forms a current pathway between the electrodes, and a gate electrode to control an amount of current through the current pathway, wherein the organic semiconductor layer comprises the organic thin film according to claim 10.

13. An organic solar cell comprising the organic thin film according to claim 10.

14. A photosensor comprising the organic thin film according to claim 10.
